(19) Europäisches Patentamt
European Patent Office
Office européen des brevets

(11) **EP 4 297 192 A1**

(12) **EUROPEAN PATENT APPLICATION**
published in accordance with Art. 153(4) EPC

(43) Date of publication:
**27.12.2023 Bulletin 2023/52**

(51) International Patent Classification (IPC):
**H01R 12/70** (2011.01)  **H01R 13/6473** (2011.01)

(21) Application number: **22778814.8**

(52) Cooperative Patent Classification (CPC):
**H01R 12/57; H01R 12/79; H05K 1/11**

(22) Date of filing: **25.03.2022**

(86) International application number:
**PCT/CN2022/083211**

(87) International publication number:
**WO 2022/206632 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.03.2021 CN 202120653373 U**

(71) Applicant: **Huawei Technologies Co., Ltd.
Shenzhen, Guangdong 518129 (CN)**

(72) Inventors:
• **YANG, Zhangwei
Shenzhen, Guangdong 518129 (CN)**

• **WANG, Hongli
Shenzhen, Guangdong 518129 (CN)**
• **SU, Tien Chieh
Shenzhen, Guangdong 518129 (CN)**
• **HUANG, Shengxian
Shenzhen, Guangdong 518129 (CN)**
• **HUANG, Shuanggang
Shenzhen, Guangdong 518129 (CN)**

(74) Representative: **Maiwald GmbH
Engineering
Elisenhof
Elisenstrasse 3
80335 München (DE)**

(54) **CONNECTOR UNIT, CONNECTOR, CIRCUIT BOARD, ELECTRONIC APPARATUS, AND ELECTRONIC SYSTEM**

(57) Embodiments of this application provide a connector body, a connector, a circuit board, an electronic device, and an electronic system, and relate to the field of electronic system accessory technologies, to improve a problem of poor SI caused when different electronic components are electrically connected by using a connector. The connector body includes a first contact part and a second contact part. The first contact part includes a first contact terminal and a first pin electrically connected to the first contact terminal. The second contact part includes a second contact terminal and a second pin electrically connected to the second contact terminal. The first contact terminal and the first pin electrically connected to the first contact terminal are integrally formed. The second contact terminal and the second pin electrically connected to the second contact terminal are integrally formed. An area of a welding surface of the first pin is less than an area of a welding surface of the second pin.

FIG. 5

EP 4 297 192 A1

## Description

This application claims priority to Chinese Patent Application No. 202120653373.4, filed with the China National Intellectual Property Administration on March 30, 2021 and entitled "CONNECTOR BODY, CONNECTOR, CIRCUIT BOARD, ELECTRONIC DEVICE, AND ELECTRONIC SYSTEM", which is incorporated herein by reference in its entirety.

## TECHNICAL FIELD

This application relates to the field of electronic system accessory technologies, and in particular, to a connector body, a connector, a circuit board, an electronic device, and an electronic system.

## BACKGROUND

A connector is an indispensable component in an electronic product, and is used at a blocked position in a circuit or between isolated circuits to build a communication bridge, so that a current flows, and the circuit is further enabled to implement a preset function. With the development of electronic technologies, the connector is used more extensively. Currently, the connector has been widely used in an electronic device such as a mobile phone or a tablet. When the connector is used in an electronic device, the connector is mainly configured to electrically connect different electronic components in the electronic device to each other. For example, the connector may electrically connect a PCB (printed circuit board, printed circuit board) to an FPC (flexible printed circuit) in an electronic device.

However, using an example in which the connector is configured to electrically connect the PCB to the FPC, because characteristic impedance of the connector does not match characteristic impedance of wiring on the PCB and characteristic impedance of wiring on the FPC, a signal may be reflected in a transmission process. As a result, a problem of poor SI (signal integrity, signal integrity) may be caused.

## SUMMARY

Embodiments of this application provide a connector body, a connector, a circuit board, an electronic device, and an electronic system, to improve a problem of poor SI caused when different electronic components are electrically connected by using a connector.

To achieve the foregoing objective, this application uses the following technical solutions.

According to a first aspect, a connector body is provided. The connector body includes a first contact part and a second contact part. The first contact part includes a first contact terminal and a first pin electrically connected to the first contact terminal. The second contact part includes a second contact terminal and a second pin electrically connected to the second contact terminal. The first contact terminal and the first pin electrically connected to the first contact terminal are integrally formed. The second contact terminal and the second pin electrically connected to the second contact terminal are integrally formed. An area of a welding surface of the first pin is less than an area of a welding surface of the second pin. When the connector body is mounted on a circuit board, a size of a pad on the circuit board is designed based on a size of a pin welded on the pad. The connector body includes the first pin and the second pin, and the area of the welding surface of the first pin is less than the area of the welding surface of the second pin. Therefore, when the circuit board is designed, the circuit board includes a first pad and a second pad, and an area of a welding surface of the first pad is less than an area of a welding surface of the second pad. When the connector body is mounted on the circuit board, the welding surface of the first pin is welded on the welding surface of the first pad, and the welding surface of the second pin is welded on the welding surface of the second pad. Because a relative area between a reference ground layer of the circuit board and both the first pin and the first pad is less than a relative area between the reference ground layer of the circuit board and both the second pin and the second pad, and it can be learned based on a capacitance formula that, a parasitic capacitance between the reference ground layer of the circuit board and both the first pin and the first pad is less in comparison with a parasitic capacitance between the reference ground layer of the circuit board and both the second pin and the second pad, it can be learned based on a characteristic impedance calculation formula that, characteristic impedance of the connector body at a position of the first pin increases. In this way, a problem that the characteristic impedance of the connector body at the position of the first pin does not match characteristic impedance of wiring on the circuit board can be improved, reflection that is of a signal on the first pin and that is caused when the signal is transmitted between the connector body and the circuit board is reduced, and SI is improved. Further, reflection that is of the signal on the first pin and that is caused when the signal is transmitted between a connector and the circuit board is reduced, and the SI is improved.

In a possible implementation, a value range of the area of the welding surface of the first pin is from 0.0016 mm$^2$ to 7.8804 mm$^2$, and a value range of the area of the welding surface of the second pin is from 0.004 mm$^2$ to 8 mm$^2$. When the value range of the area of the welding surface of the first pin is from 0.0016 mm$^2$ to 7.8804 mm$^2$, the

parasitic capacitance between the reference ground layer of the circuit board and both the first pin and the first pad can be reduced, and the characteristic impedance of the connector body at the position of the first pin is increased. When the value range of the area of the welding surface of the second pin is from 0.004 mm$^2$ to 8 mm$^2$, reliability of welding between the connector body and the circuit board can be ensured.

In a possible implementation, a difference between the area of the welding surface of the second pin and the area of the welding surface of the first pin ranges from 0.024 mm$^2$ to 7.9984 mm$^2$.

In a possible implementation, the first contact part and the second contact part are arranged along a length direction of the connector body. Along a width direction of the connector body, a length of the welding surface of the first pin is less than a length of the welding surface of the second pin. During design, along the width direction of the connector body, the length of the welding surface of the first pin is less than the length of the welding surface of the second pin, so that the area of the welding surface of the first pin can be less than the area of the welding surface of the second pin.

In a possible implementation, along the width direction of the connector body, a value range of the length of the welding surface of the first pin is from 0.02 mm to 3.98 mm, and a value range of the length of the welding surface of the second pin is from 0.04 mm to 4 mm. Therefore, the length of the welding surface of the first pin can be less in comparison with the length of the welding surface of the second pin.

In a possible implementation, along the width direction of the connector body, a difference between the length of the welding surface of the second pin and the length of the welding surface of the first pin ranges from 0.02 mm to 3.98 mm.

In a possible implementation, the first pin is a high-speed signal pin, and the second pin is a non-high-speed signal pin. Herein, the high-speed signal pin is configured to transmit a high-speed signal, and the non-high-speed signal pin is configured to transmit a non-high-speed signal. Because integrity of a signal transmitted between the connector body and the circuit board is mainly related to a high-speed signal, when the first pin is the high-speed signal pin, reflection that is of the high-speed signal and that is caused when the high-speed signal is transmitted between the connector body and the circuit board may be reduced. The integrity of the signal mainly depends on the high-speed signal. In this way, the SI may be further improved.

In a possible implementation, the non-high-speed signal pin is a low-speed signal pin, a power pin, or a ground pin. The low-speed signal pin may be, for example, a control signal pin or a low-speed clock signal pin. Herein, the low-speed signal pin is configured to transmit a low-speed signal, the power pin is configured to transmit a power signal, and the ground pin is configured to transmit a ground signal.

In a possible implementation, the first contact part and the second contact part are arranged along a length direction of the connector body. An area of a section that is of the first contact terminal and that is along a width direction of the connector body is less than an area of a section that is of the second contact terminal and that is along the width direction of the connector body. Because the area of the section that is of the first contact terminal and that is along the width direction of the connector body is less than the area of the section that is of the second contact terminal and that is along the width direction of the connector body, a parasitic capacitance between the first contact terminal and a contact terminal adjacent to the first contact terminal is small. Therefore, characteristic impedance at a position of the first contact terminal is large. In this way, a problem that characteristic impedance of the connector body at the position of the first contact terminal does not match the characteristic impedance of the wiring on the circuit board can be improved, reflection that is of a signal in the first contact terminal and that is caused when the signal is transmitted between the connector body and the circuit board is reduced, and the SI is improved. Because the first pin is electrically connected to the first contact terminal, the reflection that is of the signal on the first pin and that is caused when the signal is transmitted between the connector body and the circuit board can also be further reduced.

According to a second aspect, a connector is provided. The connector includes a male connector and a connector holder, and the male connector is connected to the connector holder through buckling. The male connector is the connector body provided in the first aspect; and/or the connector holder is the connector body provided in the first aspect. When the male connector is the connector body provided in the first aspect, the male connector has a same technical effect as that of the connector body provided in the first aspect. Details are not described herein again. When the connector holder is the connector body provided in the first aspect, the connector holder has a same technical effect as that of the connector body provided in the first aspect. Details are not described herein again.

In a possible implementation, the male connector includes a first contact part and a second contact part, and the connector holder includes a first contact part and a second contact part. A first contact terminal in the first contact part of the male connector is connected to a first contact terminal in the first contact part of the connector holder through buckling. A second contact terminal in the second contact part of the male connector is connected to a second contact terminal in the second contact part of the connector holder through buckling. Therefore, the male connector can be connected to the connector holder through buckling.

In a possible implementation, the first contact terminal of the male connector is connected to the first contact terminal of the connector holder through buckling by using one contact point. The second contact terminal of the male connector is connected to the second contact terminal of the connector holder through buckling by using a plurality of contact points. Because the first contact terminal of the male connector is connected to the first contact terminal of the connector holder through buckling by using one contact point, reflection of a signal transmitted on the first contact terminal of the male connector and the first contact terminal of the connector holder can be reduced, and the SI is further improved. When the signal transmitted on the first contact terminal and the first holder contact terminal is a high-speed signal, SI of the high-speed signal may be improved. Based on this, because the second contact terminal of the male connector is connected to the second contact terminal of the connector holder through buckling by using a plurality of contact points, a buckling force between the male connector and the connector holder can be ensured, thereby ensuring buckling reliability.

In a possible implementation, the male connector further includes an auxiliary contact terminal, and a material of the auxiliary contact terminal is a non-conductive material. The first contact terminal of the male connector is further connected to the first contact terminal of the connector holder through buckling by using the auxiliary contact terminal. In this way, the buckling force between the male connector and the connector holder can be increased, thereby further ensuring the buckling reliability between the male connector and the connector holder.

In a possible implementation, the connector is a board to board BTB connector, a type-C connector, a low voltage differential signaling LVDS connector, an M.2 connector, or a WTB connector.

According to a third aspect, a circuit board is provided. The circuit board includes a signal terminal layer and a reference ground layer that are disposed in a stacked manner. The reference ground layer covers the signal terminal layer. The signal terminal layer includes a first pad and a second pad. An area of a welding surface of the first pad is less than an area of a welding surface of the second pad. When the connector body provided in the first aspect is mounted on the circuit board, the welding surface of the first pin is welded on the welding surface of the first pad, and the welding surface of the second pin is welded on the welding surface of the second pad. Because a relative area between the reference ground layer of the circuit board and both the first pin and the first pad is less than a relative area between the reference ground layer of the circuit board and both the second pin and the second pad, and it can be learned based on a capacitance formula that, a parasitic capacitance between the reference ground layer of the circuit board and both the first pin and the first pad is less in comparison with a parasitic capacitance between the reference ground layer of the circuit board and both the second pin and the second pad, it can be learned based on a characteristic impedance calculation formula that, characteristic impedance of the connector body at a position of the first pin increases. In this way, a problem that the characteristic impedance of the connector body at the position of the first pin does not match characteristic impedance of wiring on the circuit board can be improved, reflection that is of a signal on the first pin and a signal on the first pad and that is caused when the signals are transmitted between the connector body and the circuit board is reduced, and SI is improved. Further, reflection that is of the signal on the first pin and the signal on the first pad and that is caused when the signals are transmitted between a connector and the circuit board is reduced, and the SI is improved.

In a possible implementation, a value range of the area of the welding surface of the first pad is from 0.0055 $mm^2$ to 23.8004 $mm^2$, and a value range of the area of the welding surface of the second pad is from 0.0091 $mm^2$ to 24 $mm^2$. When the value range of the area of the welding surface of the first pad is from 0.0055 $mm^2$ to 23.8004 $mm^2$, the parasitic capacitance between the reference ground layer of the circuit board and both the first pin and the first pad can be reduced, and the characteristic impedance of the connector body at the position of the first pin is increased. When the value range of the area of the welding surface of the second pad is from 0.0091 $mm^2$ to 24 $mm^2$, reliability of welding between the connector body and the circuit board can be ensured.

In a possible implementation, a difference between the area of the welding surface of the second pad and the area of the welding surface of the first pad ranges from 0.0036 $mm^2$ to 23.9945 $mm^2$.

In a possible implementation, the first pad and the second pad are arranged along a first direction. Along a direction perpendicular to the first direction, a length of the welding surface of the first pad is less than a length of the welding surface of the second pad. When the circuit board is designed, the length of the welding surface of the first pad is less than the length of the welding surface of the second pad along the direction perpendicular to the first direction, so that the area of the welding surface of the first pad is less than the area of the welding surface of the second pad.

In a possible implementation, along the direction perpendicular to the first direction, a value range of the length of the welding surface of the first pad is from 0.05 mm to 5.98 mm, and a range of the length of the welding surface of the second pad is from 0.07 mm to 6 mm. Therefore, the length of the welding surface of the first pad can be less in comparison with the length of the welding surface of the second pad.

In a possible implementation, along the direction perpendicular to the first direction, a difference between the length of the welding surface of the second pad and the length of the welding surface of the first pad ranges from 0.02 mm to 5.95 mm.

In a possible implementation, the circuit board is a printed circuit board or a flexible circuit board.

According to a fourth aspect, an electronic device is provided. The electronic device includes a circuit board and a connector body mounted on the circuit board. The connector body is the connector body provided in the first aspect, and the circuit board is the circuit board provided in the third aspect. A welding surface of a first pin of the connector body is welded on a welding surface of a first pad of the circuit board. A welding surface of a second pin of the connector body is welded on a welding surface of a second pad of the circuit board. Herein, the electronic device has a same technical effect as that of the circuit board provided in the third aspect. For details, refer to descriptions of the third aspect. Details are not described herein again.

In a possible implementation, the connector body is a male connector or a connector holder.

According to a fifth aspect, an electronic system is provided. The electronic system includes the connector provided in the fourth aspect, a first electronic component, and a second electronic component. A male connector is electrically connected to the first electronic component, and a connector holder is electrically connected to the second electronic component. The male connector includes a first pin and a second pin, an area of a welding surface of the first pin is less than an area of a welding surface of the second pin, the first electronic component is the circuit board provided in the third aspect, the first pin of the male connector is electrically connected to a first pad of the first electronic component, and the second pin of the male connector is electrically connected to a second pad of the first electronic component; and/or the connector holder includes a first pin and a second pin, an area of a welding surface of the first pin is less than an area of a welding surface of the second pin, the second electronic component is the circuit board provided in the third aspect, the first pin of the connector holder is electrically connected to a first pad of the second electronic component, and the second pin of the connector holder is electrically connected to a second pad of the second electronic component. Herein, the electronic system has a same technical effect as that of the circuit board provided in the third aspect. For details, refer to descriptions of the third aspect. Details are not described herein again.

In a possible implementation, the electronic system is a first electronic device. The connector, the first electronic component, and the second electronic component are disposed in the first electronic device.

In a possible implementation, the electronic system includes a first electronic device and a second electronic device. The male connector and the first electronic component are disposed in the first electronic device. The connector holder and the second electronic component are disposed in the second electronic device.

## BRIEF DESCRIPTION OF DRAWINGS

FIG. 1 is a schematic diagram of a structure of a first electronic device according to an embodiment of this application;

FIG. 2 is a schematic diagram of a structure of an electronic system according to an embodiment of this application;

FIG. 3 is a schematic diagram of a structure of a connector according to an embodiment of this application;

FIG. 4 is a schematic diagram of a structure in which a male connector is mounted on a first electronic component according to an embodiment of this application;

FIG. 5 is a schematic diagram of a structure of a male connector according to an embodiment of this application;

FIG. 6 is an exploded view of a male connector according to an embodiment of this application;

FIG. 7a is a schematic diagram of a structure of a first male contact part or a second male contact part according to an embodiment of this application;

FIG. 7b is a schematic diagram of a structure of a first male contact part according to an embodiment of this application;

FIG. 8 is a schematic diagram of a structure of a first circuit board or a fourth circuit board according to an embodiment of this application;

FIG. 9a is a side view of a position relationship between a first reference ground layer and both a first male pin and a first male pad or a side view of a position relationship between a second reference ground layer and both a second male pin and a second male pad according to an embodiment of this application;

FIG. 9b is a top view of a position relationship between a first reference ground layer and both a first male pin and a first male pad or a top view of a position relationship between a second reference ground layer and both a second male pin and a second male pad according to an embodiment of this application;

FIG. 10 is a schematic diagram of a structure in which a connector holder is mounted on a second electronic component according to an embodiment of this application;

FIG. 11 is a schematic diagram of a structure of a connector holder according to an embodiment of this application;

FIG. 12 is an exploded view of a connector holder according to an embodiment of this application;

FIG. 13 is a schematic diagram of a structure of a holder contact part according to an embodiment of this application;

FIG. 14 is a schematic diagram of a structure of a second circuit board according to an embodiment of this application;

FIG. 15a is a schematic diagram of a structure in which a male connector is connected to a connector holder through buckling according to an embodiment of this application;

FIG. 15b is a schematic diagram of a structure in which a male connector is connected to a connector holder through buckling according to another embodiment of this application;

FIG. 16 is a schematic diagram of a structure of a male connector according to a related technology;

FIG. 17 is a schematic diagram of a structure in which a male connector is connected to a connector holder through buckling according to a related technology;

FIG. 18 is a schematic diagram of a structure of a third circuit board according to a related technology;

FIG. 19 is a schematic diagram of a structure in which a connector holder is mounted on a second electronic component according to another embodiment of this application;

FIG. 20 is a schematic diagram of a structure of a connector holder according to an embodiment of this application; and

FIG. 21 is an exploded view of a connector holder according to an embodiment of this application.

Reference numerals: 1-First electronic device; 10-Connector; 11-Display panel; 12-Middle frame; 13-Rear housing; 20-First electronic component; 30-Second electronic component; 100-Male connector; 101-Male housing; 102-Male contact part; 102a-Male contact terminal; 102b-Male pin; 103-Male fixed pin; 104-First male contact part; 105-Second male contact part; 106-Auxiliary contact terminal; 200-Connector holder; 201-Holder housing; 202-Holder contact part; 203-Holder fixed pin; 204-Holder middle island; 205-Holder contact terminal; 206-Holder pin; 207-First holder contact part; 208-Second holder contact part; 300-First circuit board; 301-First signal terminal layer; 302-First reference ground layer; 303-First signal line layer; 400-Second circuit board; 401-Second signal terminal layer; 402-Second reference ground layer; 403-Second signal line layer; 500-Third circuit board; 501-Third signal terminal layer; 502-Third reference ground layer; 503-Third signal line layer; 600-Fourth circuit board; 601-Fourth signal terminal layer; 602-Fourth reference ground layer; 603-Fourth signal line layer; 1041-First male contact terminal; 1042-First male pin; 1051-Second male contact terminal; 1052-Second male pin; 2051-First holder contact terminal; 2052-Second holder contact terminal; 2061-First holder pin; 2062-Second holder pin; 3011-First male pad; 3012-Second male pad; 4011-Third pad; 5011-Fourth pad; 5021-Hollow area; 6011-First holder pad; and 6012-Second holder pad.

## DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The following terms "first", "second" and the like are merely intended for ease of description, and shall not be understood as an indication or implication of relative importance or implicit indication of a quantity of indicated technical features. Therefore, a feature limited by "first" or "second" and the like may explicitly or implicitly include one or more features. In the descriptions of this application, unless otherwise stated, "a plurality of" means two or more than two.

In embodiments of this application, unless otherwise specified and limited, the term "electrical connection" may be a direct electrical connection, or may be an indirect electrical connection through an intermediate dielectric.

In addition, in embodiments of this application, the word "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the word "example", "for example" or the like is intended to present a relative concept in a specific manner.

In embodiments of this application, the term "and/or" describes an association relationship between associated objects and may indicate three relationships. For example, A and/or B may indicate the following cases: Only A exists, both A and B exist, and only B exists, where A and B may be singular or plural. The character "/" generally indicates an "or" relationship between the associated objects.

In embodiments of this application, for example, "upper", "lower", "left", "right", "front", and "rear" are used to explain that structures and motion directions of different components in this application are relative. These indications are appropriate when the components are in positions shown in the figure. However, if descriptions of the positions of the components change, these direction indications change accordingly.

An embodiment of this application provides an electronic system. The electronic system may be an electronic device, for example, a first electronic device. Alternatively, the electronic system may include a plurality of electronic devices, for example, a second electronic device and a third electronic device.

The first electronic device, the second electronic device, and the third electronic device each may be, for example, a mobile phone (mobile phone), a tablet computer (pad), a personal digital assistant (personal digital assistant, PDA), a television, an intelligent wearable product (for example, a smartwatch or a smart band), a virtual reality (virtual reality, VR) terminal device, an augmented reality (augmented reality, AR) terminal device, or a cable assembly. Specific implementations of the first electronic device, the second electronic device, and the third electronic device are not specially limited in embodiments of this application.

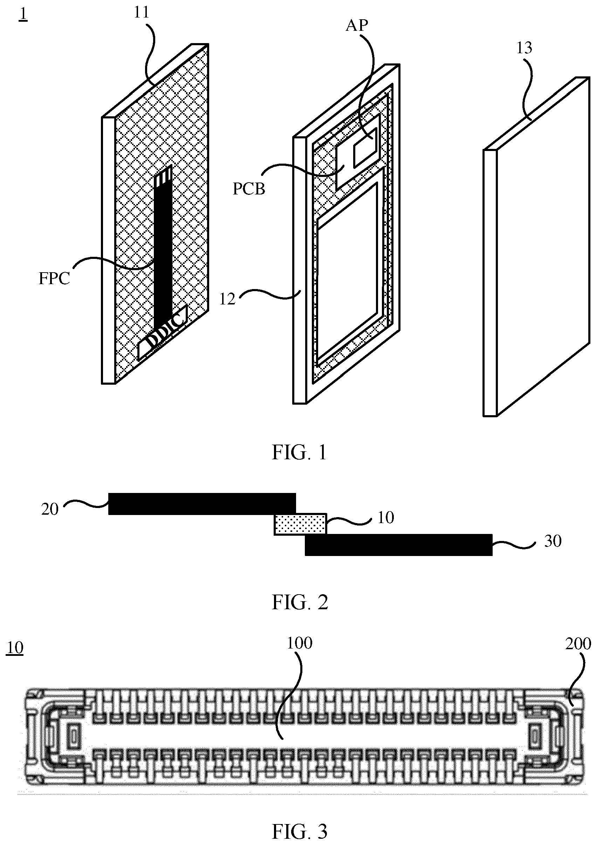

For ease of description, an example in which the first electronic device is a mobile phone is used for description below. When the second electronic device or the third electronic device is a mobile phone, for structures of the second electronic device and the third electronic device, refer to a structure of the first electronic device. As shown in FIG. 1, a structure of a first electronic device 1 mainly includes a display panel 11, a middle frame 12, and a rear housing 13. The display panel 11 and the rear housing 13 are respectively located on two sides of the middle frame 12, and are connected by using the middle frame 12.

The display panel 11 includes a plurality of pixels located in an active area (active area, AA). The first electronic device 1 may further include a display driver circuit configured to drive the plurality of pixels to display, and the display driver circuit may be electrically connected to the plurality of pixels. For example, the display driver circuit may be a display driver integrated circuit (display driver integrated circuit, DDIC). The DDIC may be disposed in a non-display area of the display panel, or may be disposed independently of the display panel 11.

The first electronic device 1 may further include a printed circuit board (printed circuit board, PCB) disposed on the middle frame 12, and a system-on-a-chip (System-On-a-Chip, SoC) and a power management chip (power IC) that are mounted on the PCB. An application processor (application processor, AP) may be disposed in the SoC. The power IC is not shown in FIG. 1.

The DDIC in FIG. 1 may be electrically connected to the PCB by using a flexible circuit board (flexible printed circuit, FPC). In this way, the power IC on the PCB may provide an operating voltage for the DDIC, and the AP on the PCB may provide display data for the DDIC, to display actual image information. The DDIC is configured to receive a signal transmitted by the PCB, and transmit the signal to the display panel 11 based on specific time sequence control, to drive the display panel 11 to emit light. The FPC provides a signal transmission connection path between the PCB and the display panel 11. One end of the FPC is bound (bonding) to the display panel 11 by using a contradirectional conductive film, and the other end is electrically connected to the PCB.

As shown in FIG. 2, a main structure of the electronic system provided in this embodiment of this application includes a connector 10, a first electronic component 20, and a second electronic component 30. The connector includes two connector bodies. The two connector bodies may be a male connector and a connector holder respectively. The male connector is connected to the connector holder through buckling. The male connector is electrically connected to the first electronic component 20, and the connector holder is electrically connected to the second electronic component 30.

Because the male connector is electrically connected to the first electronic component 20, the connector holder is electrically connected to the second electronic component 30, and the male connector is connected to the connector holder through buckling, the first electronic component 20 and the second electronic component 30 may be electrically connected by using the connector.

When the electronic system is the first electronic device, the male connector, the connector holder, the first electronic component 20, and the second electronic component 30 are all used in the first electronic device. In other words, the first electronic device includes the male connector, the connector holder, the first electronic component 20, and the second electronic component 30.

For example, the first electronic device may be the foregoing mobile phone, the first electronic component 20 may be the FPC in the mobile phone, and the second electronic component 30 may be the PCB in the mobile phone. The male connector is electrically connected to the FPC, and the connector holder is electrically connected to the PCB. In this way, the FPC and the PCB in the mobile phone may be electrically connected by using the connector 10.

When the electronic system includes the second electronic device and the third electronic device, the male connector and the first electronic component 20 electrically connected to the male connector may be used in one electronic device, and the connector holder and the second electronic component 30 electrically connected to the connector holder may be used in another electronic device. That is, the second electronic device includes the male connector and the first electronic component 20 electrically connected to the male connector, and the third electronic device includes the connector holder and the second electronic component 30 electrically connected to the connector holder.

For example, the second electronic device may be a cable assembly, the first electronic component 20 may be a cable, the third electronic device may be a television, and the second electronic component 30 may be a PCB in the television. The male connector is electrically connected to the cable, and the connector holder is electrically connected to the PCB. In this way, the PCB in the television and the cable may be electrically connected by using the connector 10.

In addition, in some examples, both the first electronic component 20 and the second electronic component 30 may be circuit boards. In some other examples, the first electronic component 20 is a circuit board, and the second electronic component 30 is a cable. Alternatively, the first electronic component 20 is a cable, and the second electronic component 30 is a circuit board. Herein, the circuit board may be, for example, a PCB or an FPC.

The connector may be, for example, a BTB (board to board, board to board) connector, a type-C connector, an LVDS (low voltage differential signaling, low voltage differential signaling) connector, an M.2 connector, or a WTB (wire to board, wire to board) connector. The following describes the connector by using an example in which the connector 10 is a BTB connector.

The following provides four specific embodiments by way of example, to separately describe the male connector, the connector holder, the first electronic component 20 electrically connected to the male connector, and the second electronic component 30 electrically connected to the connector holder that are in the connector 10.

**Embodiment 1**

FIG. 3 is a schematic diagram that is of a structure of a connector 10 and that is seen from a side of a male connector according to an embodiment of this application. As shown in FIG. 3, the connector 10 includes a male connector 100 and a connector holder 200.

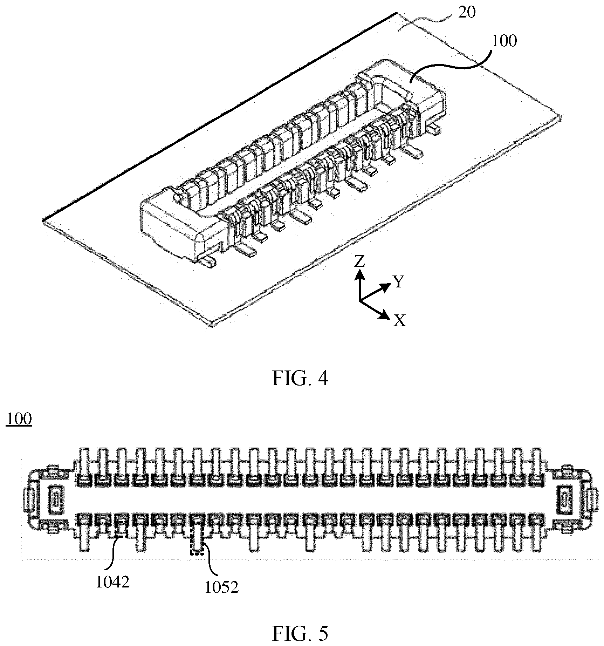

FIG. 4 is a three-dimensional diagram of the male connector 100 mounted on a first electronic component 20. The first electronic component 20 in FIG. 4 is a circuit board. Refer to FIG. 4. The male connector 100 has a straight parallelepiped profile. In addition, an extension direction of the straight-parallelepiped male connector 100 is referred to as a "length direction" (namely, a Y direction in FIG. 4), a direction that is parallel to a plane of the first electronic component 20 and that is perpendicular to the "length direction" is referred to as a "width direction" (namely, an X direction in FIG. 4), and a direction perpendicular to the plane of the first electronic component 20 is referred to as a "height direction" (namely, a Z direction in FIG. 4). In this application, for the male connector 100, a side on which the male connector 100 is mounted on the first electronic component 20 may be referred to as a "mounting side" or a "lower side", and a side on which the male connector 100 cooperates with the connector holder 200 is referred to as a "cooperating side" or an "upper side".

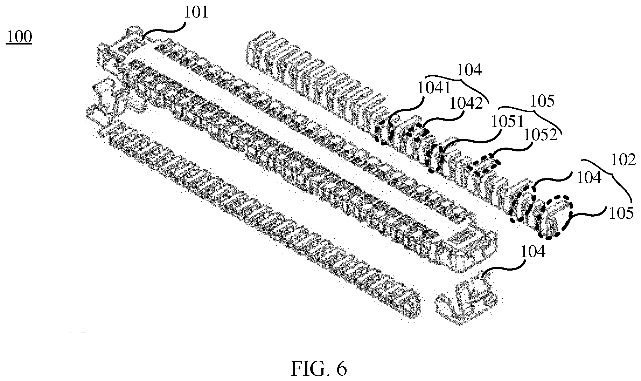

FIG. 5 is a diagram that is of a structure of the male connector 100 and that is seen from the mounting side. FIG. 6 is an exploded view of the male connector 100. FIG. 6 is an exploded view that is of the male connector 100 and that is seen from the mounting side. As shown in FIG. 6, the male connector 100 includes a housing (housing, HSG) (where for distinguishing from a housing in the connector holder 200, the housing of the male connector 100 is referred to as a male housing 101 below), a plurality of male contact parts 102, and a pair of male fixed pins (which may also be referred to as male armor) 103.

Herein, the male fixed pin 103 may be configured to, for example, transmit a power signal or a ground signal. In addition, when the male connector 100 is manufactured, the male housing 101 may be formed on the male contact part 102 and the male fixed pin 103 in an injection molding manner.

As shown in FIG. 6, the plurality of male contact parts 102 include a plurality of first contact parts and a plurality of second contact parts. To distinguish from a first contact part and a second contact part in the connector holder 200, the first contact part in the male connector 100 is referred to as a first male contact part 104, and the second contact part in the male connector 100 is referred to as a second male contact part 105.

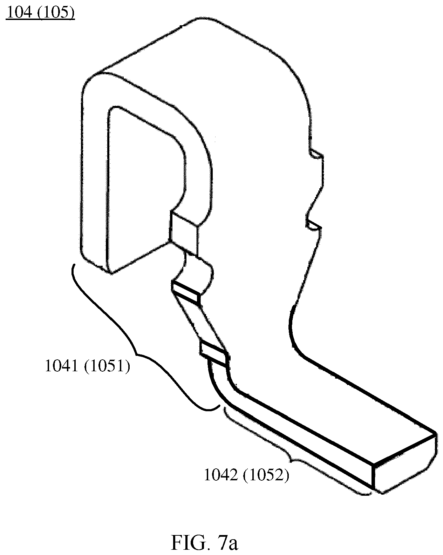

As shown in FIG. 7a, each first male contact part 104 includes a first contact terminal and a first pin (pin) electrically connected to the first contact terminal. To distinguish the first contact terminal and the first pin in the male connector 100 from a first contact terminal and a first pin in the connector holder 200, the first contact terminal in the first male contact part 104 is referred to as a first male contact terminal 1041, and the first pin in the first male contact part 104 is referred to as a first male pin 1042. The first male contact terminal 1041 and the first male pin 1042 electrically connected to the first male contact terminal 1041 are integrally formed. Each second male contact part 105 includes a second contact terminal and a second pin electrically connected to the second contact terminal. To distinguish the second contact terminal and the second pin in the male connector 100 from a second contact terminal and a second pin in the connector holder 200, the second contact terminal in the second male contact part 105 is referred to as a second male contact terminal 1051, and the second pin in the second male contact part 105 is referred to as a second male pin 1052. The second male contact terminal 1051 and the second male pin 1052 electrically connected to the second male contact terminal 1051 are integrally formed.

The first male contact terminal 1041 in the first male contact part 104 and the second male contact terminal 1051 in the second male contact part 105 are configured to be connected to the connector holder 200 through buckling, and the first male pin 1042 in the first male contact part 104 and the second male pin 1052 in the second male contact part 105 are configured to be electrically connected to the first electronic component 20, to ensure an electrical connection between the male connector 100 and the first electronic component 20. Herein, the first male pin 1042, the second male pin 1052, and the first electronic component 20 may be electrically connected through welding.

Based on this, when the male connector 100 is mounted on the first electronic component 20, the male fixed pin 103 is welded on the first electronic component 20, so that the electrical connection between the male connector 100 and the first electronic component 20 can be further strengthened.

In addition, because the first male contact part 104 includes the first male contact terminal 1041 and the first male pin 1042 electrically connected to the first male contact terminal 1041, and the second male contact part 105 includes the second male contact terminal 1051 and the second male pin 1052 electrically connected to the second male contact terminal 1051, quantities and arrangement manners of the first male contact part 104, the first male contact terminal 1041, and the first male pin 1042 are completely the same, and quantities and arrangement manners of the second male contact part 105, the second male contact terminal 1051, and the second male pin 1052 are completely the same. The first male contact part 104 and the second male contact part 105 are used as an example to describe an arrangement manner of the first male contact part 104, the first male contact terminal 1041, the first male pin 1042, the second male contact part 105, the second male contact terminal 1051, and the second male pin 1052. The plurality of

**EP 4 297 192 A1**

first male contact parts 104 and the plurality of second male contact parts 105 may be sequentially arranged on one side of the male connector 100 along the length direction of the male connector 100. The plurality of first male contact parts 104 and the plurality of second male contact parts 105 may alternatively be sequentially arranged on two opposite sides of the male connector 100 along the length direction of the male connector 100.

In addition, using the first male pin 1042 and the second male pin 1052 as an example, an arrangement manner of the first male pin 1042 and the second male pin 1052 may be set based on a requirement. For example, one or more second male pins 1052 are disposed between two adjacent first male pins 1042. For another example, two or more first male pins 1042 are in one group, and one or more second male pins 1052 are disposed between groups of first male pins 1042. For example, in FIG. 5, two first male pins 1042 are in a group, and one second male pin 1052 is disposed between groups of first male pins 1042. It should be understood that, when the first male pin 1042 is for transmitting a differential signal, an even number of first male pins 1042 need to be in one group, for example, two first male pins 1042 are in one group.

Using the first male contact part 104 and the second male contact part 105 as an example, a quantity of the first male contact parts 104 and a quantity of the second male contact parts 105 may be set based on a requirement.

Refer to FIG. 5 and FIG. 6. In this embodiment, an area of a welding surface of the first male pin 1042 is less than an area of a welding surface of the second male pin 1052.

In some examples, a value range of the area of the welding surface of the first male pin 1042 is from 0.0016 mm$^2$ to 7.8804 mm$^2$.

In some examples, the value range of the area of the welding surface of the first male pin 1042 is from 0.0016 mm$^2$ to 1.9404 mm$^2$.

For example, the area of the welding surface of the first male pin 1042 may be 0.0016 mm$^2$, 0.02 mm$^2$, 1 mm$^2$, 1.5 mm$^2$, 1.9404 mm$^2$, 5.0 mm$^2$, or 7.8804 mm$^2$.

In some examples, a value range of the area of the welding surface of the second male pin 1052 is from 0.004 mm$^2$ to 8 mm$^2$.

In some examples, the value range of the area of the welding surface of the second male pin 1052 is from 0.004 mm$^2$ to 2 mm$^2$.

For example, the area of the welding surface of the second male pin 1052 may be 0.004 mm$^2$, 0.01 mm$^2$, 0.1 mm$^2$, 1 mm$^2$, 1.5 mm$^2$, 2 mm$^2$, 5 mm$^2$, or 8 mm$^2$.

In some examples, a difference between the area of the welding surface of the second male pin 1052 and the area of the welding surface of the first male pin 1042 ranges from 0.024 mm$^2$ to 7.9984 mm$^2$.

In some examples, the difference between the area of the welding surface of the second male pin 1052 and the area of the welding surface of the first male pin 1042 ranges from 0.024 mm$^2$ to 1.9984 mm$^2$.

For example, the difference between the area of the welding surface of the second male pin 1052 and the area of the welding surface of the first male pin 1042 may be 0.024 mm$^2$, 0.03 mm$^2$, 1 mm$^2$, 1.5 mm$^2$, or 1.9984 mm$^2$.

When the area of the welding surface of the first male pin 1042 is less than the area of the welding surface of the second male pin 1052, in some examples, the first contact part 102 and the second contact part 103 are arranged along the length direction of the male connector 100. Along the width direction of the male connector 100, a length of the welding surface of the first male pin 1042 is less than a length of the welding surface of the second male pin 1052.

In some examples, along the width direction of the male connector 100, a value range of the length of the welding surface of the first male pin 1042 is from 0.02 mm to 3.98 mm.

In some examples, along the width direction of the male connector 100, a value range of the length of the welding surface of the first male pin 1042 is from 0.02 mm to 1.98 mm.

For example, along the width direction of the male connector 100, the length of the welding surface of the first male pin 1042 may be 0.02 mm, 1 mm, 1.98 mm, 2 mm, 3 mm, or 3.98 mm.

In some examples, along the width direction of the male connector 100, a value range of the length of the welding surface of the second male pin 1052 is from 0.04 mm to 4 mm.

In some examples, along the width direction of the male connector 100, a value range of the length of the welding surface of the second male pin 1052 is from 0.04 mm to 2 mm.

For example, along the width direction of the male connector 100, the length of the welding surface of the second male pin 1052 may be 0.04 mm, 0.1 mm, 1 mm, 2 mm, 2.5 mm, or 5 mm.

In some examples, along the width direction of the male connector 100, a difference between the length of the welding surface of the second male pin 1052 and the length of the welding surface of the first male pin 1042 ranges from 0.02 mm to 3.98 mm.

In some examples, along the width direction of the male connector 100, a difference between the length of the welding surface of the second male pin 1052 and the length of the welding surface of the first male pin 1042 ranges from 0.02 mm to 1.98 mm.

For example, along the width direction of the male connector 100, the difference between the length of the welding surface of the second male pin 1052 and the length of the welding surface of the first male pin 1042 may be 0.02 mm, 0.1 mm, 1 mm, 1.98 mm, 3 mm, or 3.98 mm.

Based on this, along the length direction of the male connector 100, a width of the welding surface of the first male pin 1042 may be the same as or different from a width of the welding surface of the second male pin 1052.

In some examples, along the length direction of the male connector 100, a value range of the width of the welding surface of the first male pin 1042 is from 0.08 mm to 1.98 mm.

In some examples, along the length direction of the male connector 100, a value range of the width of the welding surface of the first male pin 1042 is from 0.08 mm to 0.98 mm.

For example, along the length direction of the male connector 100, the width of the welding surface of the first male pin 1042 may be 0.08 mm, 0.98 mm, 1 mm, or 1.98 mm.

In some examples, along the length direction of the male connector 100, a value range of the width of the welding surface of the second male pin 1052 is from 0.1 mm to 2 mm.

In some examples, along the length direction of the male connector 100, a value range of the width of the welding surface of the second male pin 1052 is from 0.1 mm to 1 mm.

For example, along the length direction of the male connector 100, the width of the welding surface of the second male pin 1052 may be 0.1 mm, 0.8 mm, 1 mm, 1.5 mm, or 2 mm.

In some examples, along the length direction of the male connector 100, a difference between the width of the welding surface of the second male pin 1052 and the width of the welding surface of the first male pin 1042 ranges from 0.02 mm to 1.92 mm.

In some examples, along the length direction of the male connector 100, a difference between the width of the welding surface of the second male pin 1052 and the width of the welding surface of the first male pin 1042 ranges from 0.02 mm to 0.92 mm.

For example, along the length direction of the male connector 100, the difference between the width of the welding surface of the second male pin 1052 and the width of the welding surface of the first male pin 1042 may be 0.02 mm, 0.92 mm, 1 mm, 1.5 mm, or 1.92 mm.

It should be noted that, during appearance inspection, to detect a welding status of each of the first male pin 1042 and the second male pin 1052 with the first electronic component 20, all the first male pins 1042 and second male pins 1052 need to be visible. When the length of the welding surface of the first male pin 1042 is small along the width direction of the male connector 100, to ensure that the first male pin 1042 is visible, a part that is of the male housing 101 and that is located at the first male pin 1042 may be synchronously retracted with the first male pin 1042, to ensure that all the first male pins 1042 and second male pins 1052 are visible, so as to facilitate quality check after welding.

Based on the foregoing descriptions, in this embodiment, the first electronic component 20 electrically connected to the male connector 100 is a circuit board, and is referred to as a first circuit board below for ease of distinguishing from another circuit board in embodiments of this application. The first circuit board may be a PCB or an FPC.

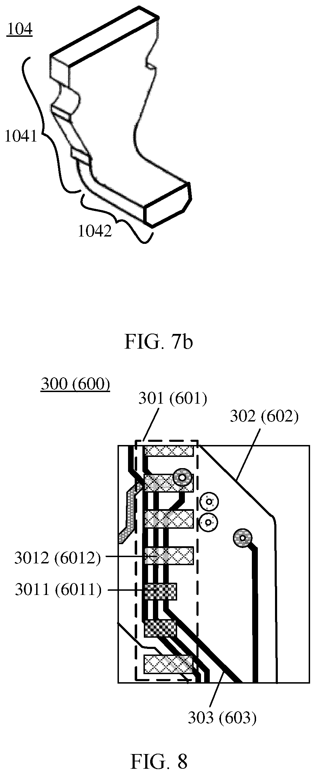

As shown in FIG. 8, a first circuit board 300 includes a signal terminal layer, a reference ground layer (which may also be referred to as a GND layer), and a signal line layer that are sequentially disposed in a stacked manner. To distinguish the signal terminal layer, the reference ground layer, and the signal line layer in the first circuit board 300 from a signal terminal layer, a reference ground layer, and a signal line layer in another circuit board in embodiments of this application, the signal terminal layer in the first circuit board 300 is referred to as a first signal terminal layer 301, the reference ground layer in the first circuit board 300 is referred to as a first reference ground layer 302, and the signal line layer in the first circuit board 300 is referred to as a first signal line layer 303. The first reference ground layer 302 covers the first signal terminal layer 301. Because the first reference ground layer 302 covers the first signal terminal layer 301, mutual interference between the first signal terminal layer 301 and the first signal line layer 303 can be avoided. The first signal terminal layer 301 includes a plurality of pads (pads).

It should be understood that, to separate the first signal terminal layer 301 from the first reference ground layer 302, the first circuit board 300 further includes a first insulation layer disposed between the first signal terminal layer 301 and the first reference ground layer 302. Similarly, to separate the first reference ground layer 302 from the first signal line layer 303, the first circuit board 300 further includes a second insulation layer disposed between the first reference ground layer 302 and the first signal line layer 303. The first insulation layer and the second insulation layer are not shown in FIG. 8.

It may be understood that a size of a pad on the first circuit board 300 is designed based on a size of a pin welded on the pad. When the male connector 100 is mounted on the first circuit board 300, both the welding surface of the first male pin 1042 and the welding surface of the second male pin 1052 of the male connector 100 are welded on a welding surface of the pad on the first circuit board 300, to implement an electrical connection between the male connector 100 and the first circuit board 300. The male connector 100 in this embodiment includes the first male pin 1042 and the second male pin 1052, and the area of the welding surface of the first male pin 1042 is less than the area of the welding surface of the second male pin 1052. Therefore, the first signal terminal layer 301 in this embodiment includes a first pad and a second pad. To distinguish the first pad and the second pad that are on the first circuit board 300 electrically connected to the male connector 100 from a first pad and a second pad that are on a fourth circuit board electrically connected to the connector holder 200, the first pad on the first circuit board 300 electrically connected to the male connector 100 is referred to as a first male pad 3011, and the second pad on the first circuit board 300 electrically connected to the male connector 100 is referred to as a second male pad 3012. An area of a welding surface of the first male pad 3011 is less than an area of a welding surface of the second male pad 3012.

In some examples, a value range of the area of the welding surface of the first male pad 3011 is from 0.0055 mm$^2$ to 23.8004 mm$^2$.

In some examples, a value range of the area of the welding surface of the first male pad 3011 is from 0.0055 mm$^2$ to 11.8604 mm$^2$.

For example, the area of the welding surface of the first male pad 3011 may be 0.0055 mm$^2$, 1 mm$^2$, 5.0 mm$^2$, 11.8604 mm$^2$, 15 mm$^2$, 20 mm$^2$, or 23.8004 mm$^2$.

In some examples, a value range of the area of the welding surface of the second male pad 3012 is from 0.0091 mm$^2$ to 24 mm$^2$. In some examples, a value range of the area of the welding surface of the second male pad 3012 is from 0.0091 mm$^2$ to 12 mm$^2$.

For example, the area of the welding surface of the second male pad 3012 may be 0.0091 mm$^2$, 1 mm$^2$, 5.0 mm$^2$, 12 mm$^2$, 20 mm$^2$, or 24 mm$^2$.

In some examples, a difference between the area of the welding surface of the second male pad 3012 and the area of the welding surface of the first male pad 3011 ranges from 0.0036 mm$^2$ to 23.9945 mm$^2$.

In some examples, a difference between the area of the welding surface of the second male pad 3012 and the area of the welding surface of the first male pad 3011 ranges from 0.0036 mm$^2$ to 11.9945 mm$^2$.

It should be understood that both the welding surface of the first male pin 1042 and the welding surface of the first male pad 3011 are parallel to the first reference ground layer 302.

When the first electronic component 20 is the first circuit board 300, and the male connector 100 is mounted on the first electronic component 20, the welding surface of the first male pin 1042 of the male connector 100 is welded on the welding surface of the first male pad 3011 of the first circuit board 300, and the welding surface of the second male pin 1052 of the male connector 100 is welded on the welding surface of the second male pad 3012 of the first circuit board 300, to implement the electrical connection between the male connector 100 and the first circuit board 300.

When the area of the welding surface of the first male pad 3011 is less than the area of the welding surface of the second male pad 3012, in some examples, the first male pad 3011 and the second male pad 3012 are arranged along a first direction. Along a direction perpendicular to the first direction, a length of the welding surface of the first male pad 3011 is less than a length of the welding surface of the second male pad 3012.

In some examples, along the direction perpendicular to the first direction, a value range of the length of the welding surface of the first male pad 3011 is from 0.05 mm to 5.98 mm.

In some examples, along the direction perpendicular to the first direction, a value range of the length of the welding surface of the first male pad 3011 is from 0.05 mm to 3.98 mm.

For example, along the direction perpendicular to the first direction, the length of the welding surface of the first male pad 3011 may be 0.05 mm, 1 mm, 1.5 mm, 3 mm, 3.98 mm, or 5.98 mm.

In some examples, along the direction perpendicular to the first direction, a value range of the length of the welding surface of the second male pad 3012 is from 0.07 mm to 6 mm.

In some examples, along the direction perpendicular to the first direction, a value range of the length of the welding surface of the second male pad 3012 is from 0.07 mm to 4 mm.

For example, along the direction perpendicular to the first direction, the length of the welding surface of the second male pad 3012 may be 0.07 mm, 1 mm, 2 mm, 4 mm, or 6 mm.

In some examples, along the direction perpendicular to the first direction, a difference between the length of the welding surface of the second male pad 3012 and the length of the welding surface of the first male pad 3011 ranges from 0.02 mm to 5.95 mm.

In some examples, along the direction perpendicular to the first direction, a difference between the length of the welding surface of the second male pad 3012 and the length of the welding surface of the first male pad 3011 ranges from 0.02 mm to 3.95 mm.

For example, along the direction perpendicular to the first direction, the difference between the length of the welding surface of the second male pad 3012 and the length of the welding surface of the first male pad 3011 may be 0.02 mm, 1 mm, 2 mm, 3.95 mm, 5 mm, or 5.95 mm.

Based on this, along the first direction, a width of the welding surface of the first male pad 3011 may be the same as or different from a width of the welding surface of the second male pad 3012.

In some examples, along the first direction, a value range of the width of the welding surface of the first male pad 3011 is from 0.11 mm to 3.98 mm.

In some examples, along the first direction, a value range of the width of the welding surface of the first male pad 3011 is from 0.11 mm to 2.98 mm.

For example, along the first direction, the width of the welding surface of the first male pad 3011 may be 0.11 mm, 2 mm, 2.98 mm, 3 mm, or 3.98 mm.

In some examples, along the first direction, a value range of the width of the welding surface of the second male pad 3012 is from 0.13 mm to 4 mm.

In some examples, along the first direction, a value range of the width of the welding surface of the second male pad 3012 is from 0.13 mm to 3 mm.

For example, along the first direction, the width of the welding surface of the second male pad 3012 may be 0.13 mm, 1 mm, 3 mm, or 4 mm.

In some examples, along the first direction, a difference between the width of the welding surface of the second male pad 3012 and the width of the welding surface of the first male pad 3011 ranges from 0.02 mm to 3.89 mm.

In some examples, along the first direction, a difference between the width of the welding surface of the second male pad 3012 and the width of the welding surface of the first male pad 3011 ranges from 0.02 mm to 2.89 mm.

For example, along the first direction, the difference between the width of the welding surface of the second male pad 3012 and the width of the welding surface of the first male pad 3011 may be 0.02 mm, 1 mm, 1.5 mm, 2 mm, 2.89 mm, or 3.89 mm.

It should be understood that the circuit board, for example, the PCB or the FPC, is usually formed by a plurality of film layers, the film layer is thin, and density of wiring on the circuit board is high. As a result, characteristic impedance of the wiring on the circuit board is usually large. However, characteristic impedance of the connector 10 is usually small. To be specific, characteristic impedance of the male connector 100 and the connector holder 200 in the connector 10 is usually small. When the male connector 100 is electrically connected to the first circuit board 300, if the characteristic impedance of the male connector 100 does not match characteristic impedance of wiring on the first circuit board 300 (where the characteristic impedance of the male connector 100 is usually less than the characteristic impedance of the wiring on the first circuit board 300), a signal is reflected when the signal is transmitted between the male connector 100 and the first circuit board 300. As a result, a problem of poor SI is caused.

$$Z=\sqrt{\frac{L}{C}}$$

It can be learned based on a characteristic impedance calculation formula $Z=\sqrt{\frac{L}{C}}$, where Z is characteristic impedance, L is a parasitic inductance, and C is a parasitic capacitance, that the characteristic impedance Z of the male connector 100 is related to a parasitic capacitance between the male connector 100 and the first circuit board 300. A smaller parasitic capacitance between the male connector 100 and the first circuit board 300 indicates larger characteristic impedance of the male connector 100.

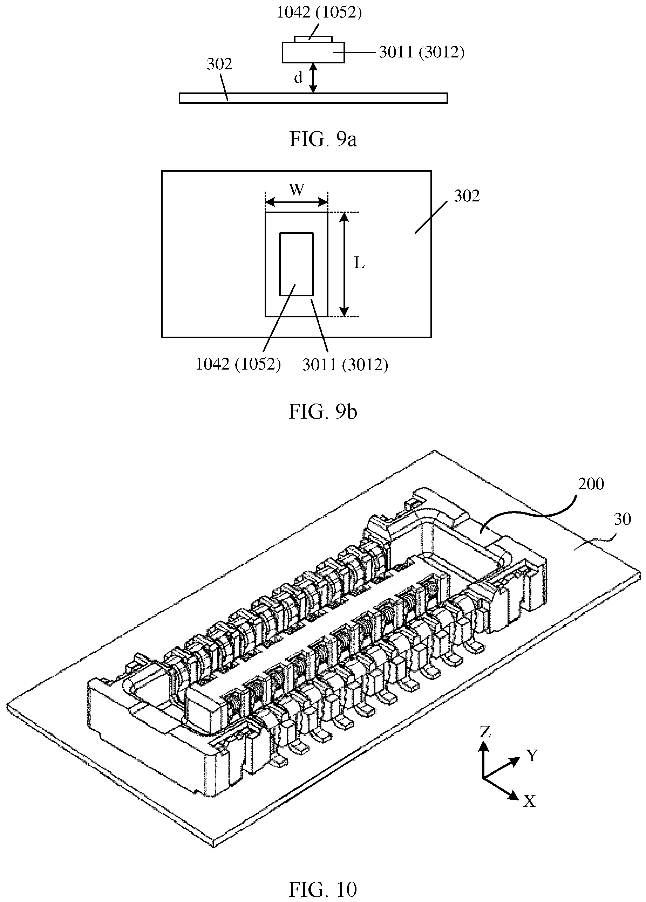

Refer to FIG. 9a and FIG. 9b. It can be learned based on a structure of the first circuit board 300 that, a parasitic capacitance is generated between the first reference ground layer 302 of the first circuit board 300 and the pad on the first circuit board 300, namely, both the first male pad 3011 and the second male pad 3012. When the male connector 100 is electrically connected to the first circuit board 300, the welding surface of the first male pin 1042 of the male connector 100 is welded on the welding surface of the first male pad 3011, and the welding surface of the second male pin 1052 is welded on the welding surface of the second male pad 3012. Therefore, the parasitic capacitance between the male connector 100 and the first circuit board 300 is the parasitic capacitance between the first reference ground layer 302 and both the first male pad 3011 and the second male pad 3012 of the first circuit board 300. In FIG. 9a, d represents a distance between the first male pad 3011 or the second male pad 3012 and the first reference ground layer 302. In FIG. 9b, L represents the length of the welding surface of the first male pad 3011 along the direction perpendicular to the first direction, and W represents the width of the welding surface of the first male pad 3011 along the first direction. Alternatively, L represents the length of the welding surface of the second male pad 3012 along the direction perpendicular to the first direction, and W represents the width of the welding surface of the second male pad 3012 along the first direction.

In this embodiment, when the male connector 100 is mounted on the first circuit board 300, because the area of the welding surface of the first male pin 1042 of the male connector 100 is less than the area of the welding surface of the second male pin 1052, the area of the welding surface of the first male pad 3011 of the first circuit board 300 is less than the second male pad 3012, the welding surface of the first male pin 1042 is welded on the welding surface of the first male pad 3011, and the welding surface of the second male pin 1052 is welded on the welding surface of the second male pad 3012, a relative area between the first reference ground layer 302 of the first circuit board 300 and both the first male pin 1042 and the first male pad 3011 is less than a relative area between the first reference ground layer 302 of the first circuit board 300 and both the second male pin 1052 and the second male pad 3012. It can be learned based on a capacitance formula $C=\frac{\varepsilon S}{d}$, where C is a capacitance, $\varepsilon$ is a dielectric constant, S is an area that two electrode plates face, and d is a distance between the two electrode plates, that a parasitic capacitance between the first reference ground layer 302 of the first circuit board 300 and both the first male pin 1042 and the first male pad 3011 is less in comparison with a parasitic capacitance between the first reference ground layer 302 of the first circuit board 300 and both the second male pin 1052 and the second male pad 3012. Therefore, it can be learned based on the characteristic impedance calculation formula that, characteristic impedance of the male connector 100 at a position of the first male pin 1042 increases. In this way, a problem that the characteristic impedance of the male connector 100 at the position of the first male pin 1042 does not match the characteristic impedance of the wiring on the first circuit board 300 can be improved, reflection that is of a signal on the first male pin 1042 and that is caused when the signal is transmitted between the male connector 100 and the first circuit board 300 is reduced, and SI is improved.

Based on this, in this embodiment, when the characteristic impedance of the male connector 100 at the position of the first male pin 1042 is increased, because the area of the welding surface of the second male pin 1052 and the area of the welding surface of the second male pad 3012 are large, the welding surface of the second male pin 1052 may be welded on the welding surface of the second male pad 3012, so that a welding force between the male connector 100 and the first circuit board 300 is large, to ensure that the male connector 100 and the first circuit board 300 are firmly connected.

It should be noted that, if a bonding force between the male connector 100 and the first circuit board 300 is insufficient, the length and/or the width of the welding surface of the second male pin 1052 may be further increased, to ensure that a welding force between the male pin 105 of the male connector 100 and the first circuit board 300 satisfies a requirement.

It should be understood that, because the male connector 100 includes a plurality of first male contact terminals 1041 and a plurality of second male contact terminals 1051 arranged along the length direction of the male connector 100, a parasitic capacitance may also be generated between two adjacent male contact terminals (where the two male contact terminals may be two first male contact terminals 1041, may be two second male contact terminals 1051, or certainly may be one first male contact terminal 1041 and one second male contact terminal 1051). The parasitic capacitance also affects the characteristic impedance of the male connector 100. When the male connector 100 is connected to the connector holder 200 through buckling, both the first male contact terminal 1041 and the second male contact terminal 1051 need to contact the connector holder 200. If areas of sections that are of all the first male contact terminals 1041 and all the second male contact terminals 1051 and that are along the width direction of the male connector 100 are reduced, a buckling force may be insufficient when the male connector 100 is connected to the connector holder 200 through buckling. As a result, buckling reliability between the male connector 100 and the connector holder 200 may be affected.

Based on this, in this embodiment, areas of sections that are of a part of the male contact terminals and that are along the width direction of the male connector 100 may be reduced, so that the parasitic capacitance between two adjacent male contact terminals can be reduced, and the buckling reliability between the male connector 100 and the connector holder 200 can be ensured.

In some examples, an area of a section that is of the first male contact terminal 1041 and that is along the width direction of the male connector 100 is less than an area of a section that is of the second male contact terminal 1051 and that is along the width direction of the male connector 100.

Because the area of the section that is of the first male contact terminal 1041 and that is along the width direction of the male connector 100 is less than the area of the section that is of the second male contact terminal 1051 and that is along the width direction of the male connector 100, a parasitic capacitance between the first male contact terminal 1041 and the second male contact terminal 1051 adjacent to the first male contact terminal 1041 is small. Therefore, characteristic impedance at a position of the first male contact terminal 1041 is large. In this way, a problem that characteristic impedance of the male connector 100 at the position of the first male contact terminal 1041 does not match the characteristic impedance of the wiring on the first circuit board 300 can be improved, reflection that is of a signal in the first male contact terminal 1041 and that is caused when the signal is transmitted between the male connector 100 and the first circuit board 300 is reduced, and the SI is improved. Because the first male pin 1042 is electrically connected to the first male contact terminal 1041, the reflection that is of the signal on the first male pin 1042 and that is caused when the signal is transmitted between the male connector 100 and the first circuit board 300 can also be further reduced.

FIG. 7b is a schematic diagram of a structure of the first male contact part 104 according to an embodiment of this application. The first male contact part 104 includes the first male contact terminal 1041 and the first male pin 1042. When the male contact part 102 provided in FIG. 7a is the second male contact part 105, and the second male contact part 105 includes the second male contact terminal 1051 and the second male pin 1052, it can be learned by comparing FIG. 7a and FIG. 7b that, in comparison with the second male contact terminal 1051, the first male contact terminal 1041 is reduced by a part, so that the area of the section that is of the first male contact terminal 1041 and that is along the width direction of the male connector 100 can be less than the area of the section that is of the second male contact terminal 1051 and that is along the width direction of the male connector 100.

Considering that integrity of a signal transmitted between the male connector 100 and the first circuit board 300 is mainly related to a high-speed signal, in some examples, the first male pin 1042 is a high-speed signal (high-speed signal, HS signal) pin, and the second male pin 1052 is a non-high-speed signal pin.

Herein, the non-high-speed signal pin may be, for example, a low-speed signal pin, a power pin, or a ground pin. The low-speed signal pin may be, for example, a control signal pin or a low-speed clock signal pin.

It should be understood that, because the first male pin 1042 is electrically connected to the first male contact terminal 1041, and the welding surface of the first male pin 1042 is welded on the welding surface of the first male pad 3011, when the first male pin 1042 is the high-speed signal pin, both the first male contact terminal 1041 and the first male pad 3011 transmit high-speed signals. Similarly, because the second male pin 1052 is electrically connected to the second male contact terminal 1051, and the welding surface of the second male pin 1052 is welded on the welding surface of the second male pad 3012, when the second male pin 1052 is the non-high-speed signal pin, both the second male contact terminal 1051 and the second male pad 3012 transmit non-high-speed signals.

Because the first male pin 1042 is the high-speed signal pin, and the second male pin 1052 is the non-high-speed signal pin, reflection caused when a high-speed signal is transmitted between the male connector 100 and the first circuit board 300 may be reduced. Signal integrity mainly depends on the high-speed signal. In this way, the SI may be further improved.

FIG. 10 is a three-dimensional diagram of the connector holder 200 mounted on a second electronic component 30. For example, the second electronic component 30 in FIG. 10 is a circuit board. Refer to FIG. 10. The connector holder 200 has a straight parallelepiped profile. In addition, an extension direction of the straight-parallelepiped connector holder 200 is referred to as a "length direction" (namely, a Y direction in FIG. 10), a direction that is parallel to a plane of the second electronic component 30 and that is perpendicular to the "length direction" is referred to as a "width direction" (namely, an X direction in FIG. 10), and a direction perpendicular to the plane of the second electronic component 30 is referred to as a "height direction" (namely, a Z direction in FIG. 10). In this application, for the connector holder 200, a side on which the connector holder 200 is mounted on the second electronic component 30 may be referred to as a "mounting side" or a "lower side", and a side on which the connector holder 200 cooperates with the male connector 100 is referred to as a "cooperating side" or an "upper side".

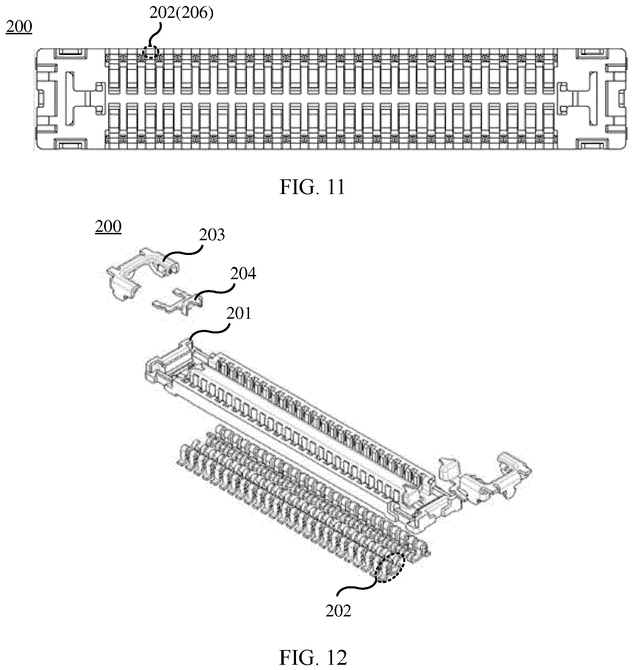

FIG. 11 is a diagram that is of a structure of the connector holder 200 and that is seen from the mounting side. FIG. 12 is an exploded view of the connector holder 200. FIG. 12 is an exploded view that is of the connector holder 200 and that is seen from the mounting side. As shown in FIG. 12, the connector holder 200 includes the housing (where for distinguishing from the housing in the male connector 100, the housing of the connector holder 200 is referred to as a holder housing 201 below), a plurality of holder contact parts 202, a pair of holder fixed pins (which may also be referred to as holder armor) 203, and a pair of holder middle islands 204. As shown in FIG. 11 and FIG. 12, sizes of the plurality of holder contact parts 202 are the same.

Herein, the holder fixed pin 203 may be configured to, for example, transmit a power signal or a ground signal. When the connector holder 200 is manufactured, the holder housing 201 may be formed on the holder contact part 202, the holder fixed pin 203, and the holder middle island 204 in an injection molding manner.

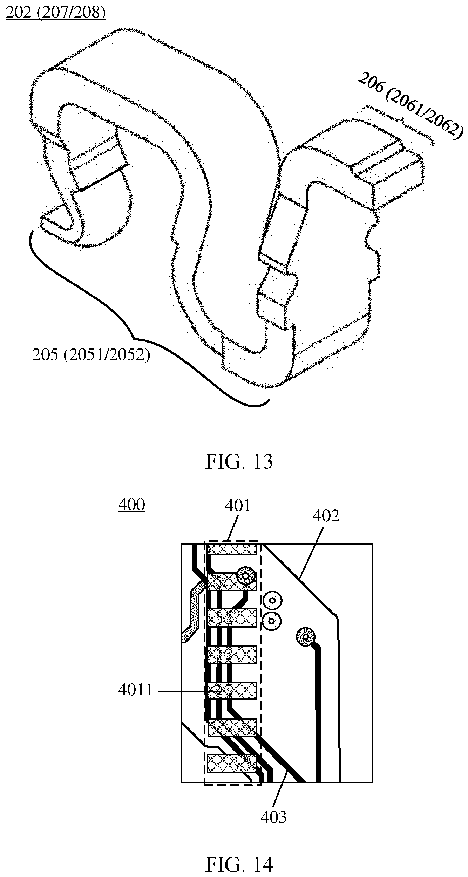

As shown in FIG. 13, each holder contact part 202 includes a holder contact terminal 205 and a holder pin 206 electrically connected to the holder contact terminal 205. The holder contact terminal 205 and the holder pin 206 electrically connected to the holder contact terminal 205 are integrally formed.

The holder contact terminal 205 in the holder contact part 202 is configured to be connected to the first male contact terminal 1041 in the first male contact part 104 and the second male contact terminal 1051 in the second male contact part 105 through buckling, and the holder pin 206 in the holder contact part 202 is configured to be electrically connected to the second electronic component 30, to ensure an electrical connection between the connector holder 200 and the second electronic component 30. Herein, the holder pin 206 and the second electronic component 30 may be electrically connected through welding.

Based on this, when the connector holder 200 is mounted on the second electronic component 30, the holder fixed pin 203 and the holder middle island 204 are welded on the second electronic component 30, so that the electrical connection between the connector holder 200 and the second electronic component 30 can be further strengthened.

In addition, because the holder contact part 202 includes the holder contact terminal 205 and the holder pin 206 electrically connected to the holder contact terminal 205, quantities and arrangement manners of the holder contact part 202, the holder contact terminal 205, and the holder pin 206 are completely the same. The holder contact part 202 is used as an example to describe an arrangement manner of the holder contact part 202, the holder contact terminal 205, and the holder pin 206. The plurality of holder contact parts 202 may be sequentially arranged on one side of the connector holder 200 along the length direction of the connector holder 200. The plurality of holder contact parts 202 may alternatively be sequentially arranged on two opposite sides of the connector holder 200 along the length direction of the connector holder 200.

It should be noted that, during appearance inspection, to detect a welding status between the holder pin 206 and the second electronic component 30, all the holder pins 206 need to be visible, to facilitate quality check after welding.

In this embodiment, because the connector holder 200 is connected to the male connector 100 through buckling, the male contact part 102 of the male connector 100 includes the first male contact part 104 and the second male contact part 105, the first male contact part 104 includes the first male contact terminal 1041 and the first male pin 1042, and the second male contact part 105 includes the second male contact terminal 1051 and the second male pin 1052, for ease of description, the plurality of holder contact parts 202 in the connector holder 200 may be divided into a first contact part and a second contact part based on the first male contact part 104 and the second male contact part 105 in the male connector 100. To distinguish from the first contact part and the second contact part in the male connector 100, the first contact part in the connector holder 200 is referred to as a first holder contact part, and the second contact part in the connector holder 200 is referred to as a second holder contact part. The first holder contact part is electrically connected to the first male contact part 104, and the second holder contact part is electrically connected to the second male contact part 105. The first holder contact part includes a first contact terminal and a first pin electrically connected to the first contact terminal, and the second holder contact part includes a second contact terminal and a second pin electrically connected to the second contact terminal. To distinguish the first pin and the second pin in the connector holder 200 from the first pin and the second pin in the male connector 100, the first pin in the connector holder 200 is referred to as a first holder pin, and the second pin in the connector holder 200 is referred to as a second holder pin. To distinguish the first contact terminal and the second contact terminal in the connector holder 200 from the first contact terminal and the second contact terminal in the male connector 100, the first contact terminal in the connector holder 200 is referred to as a first holder contact terminal, and the second contact terminal in the connector holder 200 is referred to as a second holder contact terminal. The first holder pin and the first holder contact terminal in the connector holder 200 are integrally formed, and the second holder pin and the second holder contact terminal are integrally formed. The first holder contact terminal in the connector holder 200 is connected to the first male contact terminal 1041 in the male connector 100 through buckling, and the second holder contact terminal in the connector holder 200 is connected to the second male contact terminal 1051 in the male connector 100 through buckling, so that the connector holder 200 is connected to the male connector 100 through buckling.

In this embodiment, because the sizes of the plurality of holder contact parts 202 are the same, sizes of the plurality of holder contact terminals 205 in the connector holder 200 are the same. To be specific, sizes of the first holder contact terminal and the second holder contact terminal in the connector holder 200 are the same. Sizes of the plurality of holder pins 206 in the connector holder 200 are the same. To be specific, sizes of the first holder pin and the second holder pin in the connector holder 200 are the same.

In some examples, a value range of an area of a welding surface of the holder pin 206 is the same as the value range of the area of the welding surface of the second male pin 1052. Refer to the foregoing descriptions. Details are not described herein again.

In some examples, a value range of a length of the welding surface of the holder pin 206 along the width direction of the connector holder 200 is the same as the value range of the length of the welding surface of the second male pin 1052 along the width direction of the male connector 100. Refer to the foregoing descriptions. Details are not described herein again.

In some examples, a value range of a width of the welding surface of the holder pin 206 along the length direction of the connector holder 200 is the same as the value range of the width of the welding surface of the second male pin 1052 along the length direction of the male connector 100. Refer to the foregoing descriptions. Details are not described herein again.

Based on the foregoing connection relationship, both an arrangement manner of the first holder contact terminal and the second holder contact terminal in the connector holder 200 and an arrangement manner of the first holder pin and the second holder pin in the connector holder 200 are the same as the arrangement manner of the first male pin 1042 and the second male pin 1052 in the male connector 100. For details, refer to the arrangement manner of the first male pin 1042 and the second male pin 1052 in the male connector 100. Details are not described herein again.

Based on the foregoing connector holder 200, in this embodiment, the second electronic component 30 electrically connected to the connector holder 200 may be a circuit board, for example, a PCB or an FPC, or may be a cable.

The following describes the second electronic component 30 by using an example in which the second electronic component 30 electrically connected to the connector holder 200 is a circuit board. For ease of distinguishing from another circuit board in embodiments of this application, the second electronic component 30 is referred to as a second circuit board below.

As shown in FIG. 14, a second circuit board 400 includes a signal terminal layer, a reference ground layer, and a signal line layer that are sequentially disposed in a stacked manner. To distinguish the signal terminal layer, the reference ground layer, and the signal line layer in the second circuit board 400 from a signal terminal layer, a reference ground layer, and a signal line layer in another circuit board in embodiments of this application, the signal terminal layer in the second circuit board 400 is referred to as a second signal terminal layer 401, the reference ground layer in the second circuit board 400 is referred to as a second reference ground layer 402, and the signal line layer in the second circuit board 400 is referred to as a second signal line layer 403. The second reference ground layer 402 covers the second signal terminal layer 401. Because the second reference ground layer 402 covers the second signal terminal layer 401, mutual interference between the second signal terminal layer 401 and the second signal line layer 403 can be avoided. The second signal terminal layer 401 includes a plurality of third pads 4011, and sizes of the plurality of third pads 4011 are the same.

It should be understood that, to separate the second signal terminal layer 401 from the second reference ground layer 402, the first circuit board 400 further includes a third insulation layer disposed between the second signal terminal layer 401 and the second reference ground layer 402. Similarly, to separate the second reference ground layer 402 from the second signal line layer 403, the first circuit board 400 further includes a fourth insulation layer disposed between the second reference ground layer 402 and the second signal line layer 403. The third insulation layer and the fourth insulation layer are not shown in FIG. 14.

A size of a pad on the second circuit board 400 is designed based on a size of a pin welded on the pad. In this embodiment, the sizes of the plurality of holder pins 206 in the connector holder 200 are the same. Therefore, the sizes of the plurality of third pads 4011 on the second circuit board 400 are the same.

In some examples, a value range of an area of a welding surface of the third pad 4011 is the same as the value range of the area of the welding surface of the second male pad 3012. Refer to the foregoing descriptions. Details are not described herein again.

In some examples, a value range of a length of the welding surface of the third pad 4011 along a direction perpendicular to an arrangement direction of the plurality of third pads 4011 is the same as the value range of the length of the welding surface of the second male pad 3012 along the direction perpendicular to the first direction. Refer to the foregoing descriptions. Details are not described herein again.

In some examples, a value range of a width of the welding surface of the third pad 4011 along the arrangement direction of the plurality of third pads 4011 is the same as the value range of the width of the welding surface of the second male pad 3012 along the first direction. Refer to the foregoing descriptions. Details are not described herein again.

When the second electronic component 30 is the circuit board, and the connector holder 200 is mounted on the second electronic component 30, a welding surface of the holder pin 206 of the connector holder 200 is welded on the welding surface of the third pad 4011 of the second circuit board 400, to implement an electrical connection between the connector holder 200 and the second circuit board 400.

Based on this, when the male connector 100 is connected to the connector holder 200 through buckling by using the first male contact terminal 1041 and the second male contact terminal 1051 of the male connector 100 and the holder contact terminal 205 of the connector holder 200, for example, the following two implementations may be available.

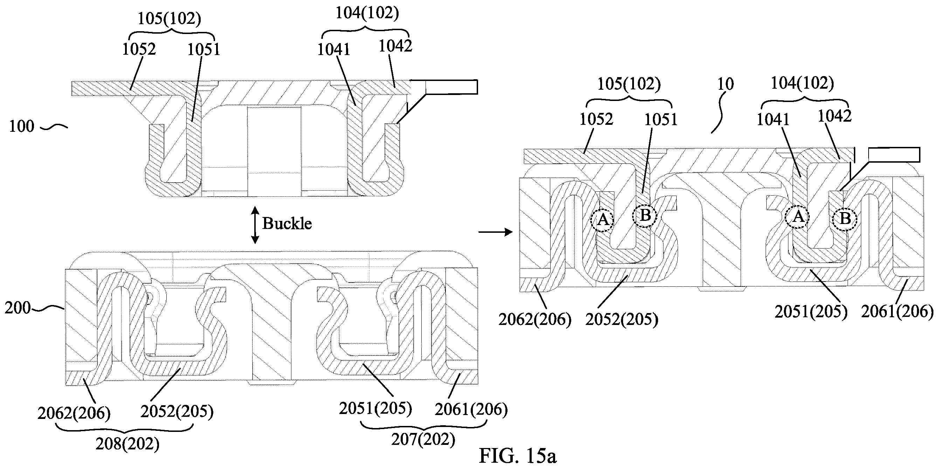

First implementation: As shown in FIG. 15a, both the first male contact terminal 1041 and the second male contact terminal 1051 of the male connector 100 in the connector 10 are connected to the holder contact terminal 205 of the connector holder 200 through buckling by using a plurality of contact points, for example, two contact points (a contact point A and a contact point B). To be specific, the first male contact terminal 1041 of the male connector 100 is connected to the first holder contact terminal 2051 of the connector holder 200 through buckling by using a plurality of contact points, for example, two contact points. The second male contact terminal 1051 of the male connector 100 is connected to the second holder contact terminal 2052 of the connector holder 200 through buckling by using a plurality of contact points, for example, two contact points.

It should be noted that the connector 10, the male connector 100, and the connector holder 200 in FIG. 15a are all shown in a schematic diagram of a section along a width direction of the connector 10.

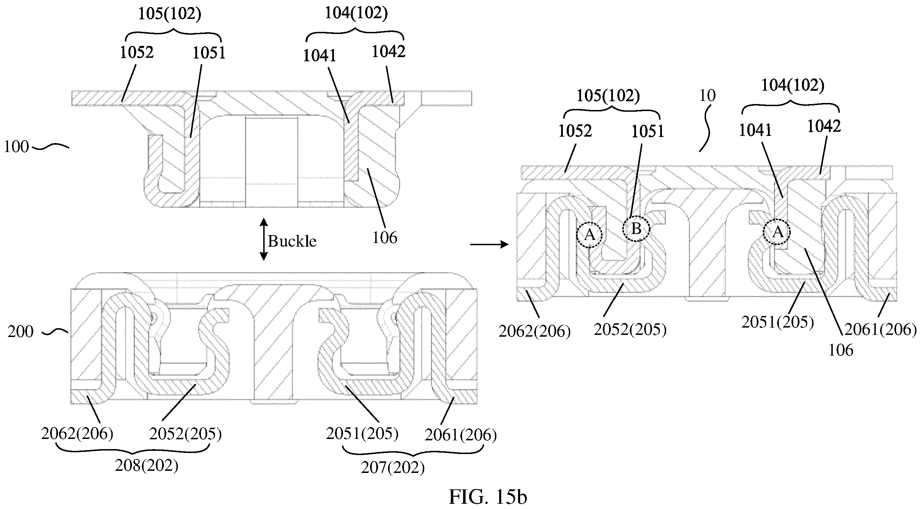

Second implementation: As shown in FIG. 15b, the first male contact terminal 1041 of the male connector 100 in the connector 10 is connected to the first holder contact terminal 2051 of the connector holder 200 through buckling by using a contact point A, and the second male contact terminal 1051 of the male connector 100 is connected to the second holder contact terminal 2052 of the connector holder 200 through buckling by using a plurality of contact points, for example, two contact points (the contact point A and a contact point B).

It should be noted that the connector 10, the male connector 100, and the connector holder 200 in FIG. 15b are all shown in a schematic diagram of the section along the width direction of the connector 10.

It should be understood that, when the male connector 100 is connected to the connector holder 200 through buckling by using the second implementation, in some examples, as shown in FIG. 15b, for the male connector 100, an area of a section that is of the first male contact terminal 1041 and that is along the width direction of the male connector 100 is less than an area of a section that is of the second male contact terminal 1051 and that is along the width direction of the male connector 100.

When the male connector 100 is connected to the connector holder 200 through buckling by using the second implementation, because the first male contact terminal 1041 of the male connector 100 is connected to the first holder contact terminal 2051 of the connector holder 200 through buckling by using the contact point A, reflection of a signal transmitted on the first male contact terminal 1041 of the male connector 100 and the first holder contact terminal 2051 of the connector holder 200 can be reduced, and the SI is further improved. When the signal transmitted on the first male contact terminal 1041 and the first holder contact terminal 2051 is a high-speed signal, SI of the high-speed signal may be improved.

Based on this, because the second male contact terminal 1051 of the male connector 100 is connected to the second holder contact terminal 2052 of the connector holder 200 through buckling by using a plurality of contact points, a buckling force between the male connector 100 and the connector holder 200 can be ensured, thereby ensuring buckling reliability.

Based on the foregoing descriptions, when the first male contact terminal 1041 of the male connector 100 in the connector 10 is connected to the first holder contact terminal 2051 of the connector holder 200 through buckling by using the contact point A, in some examples, as shown in FIG. 15b, the male connector 100 further includes an auxiliary contact terminal 106. A material of the auxiliary contact terminal 106 is a non-conductive material. The first male contact terminal 1041 of the male connector 100 is further connected to the first holder contact terminal 2051 of the connector holder 200 through buckling by using the auxiliary contact terminal 106.

Herein, the non-conductive material may be, for example, plastic or rubber.

When the first male contact terminal 1041 of the male connector 100 in the connector 10 is connected to the first holder contact terminal 2051 of the connector holder 200 through buckling by using the contact point A, the male connector 100 further includes the auxiliary contact terminal 106, and the first male contact terminal 1041 of the male connector 100 is further connected to the first holder contact terminal 2051 of the connector holder 200 through buckling by using the auxiliary contact terminal 106. Therefore, the buckling force between the male connector 100 and the connector holder 200 can be increased, thereby further ensuring the buckling reliability between the male connector 100 and the connector holder 200.

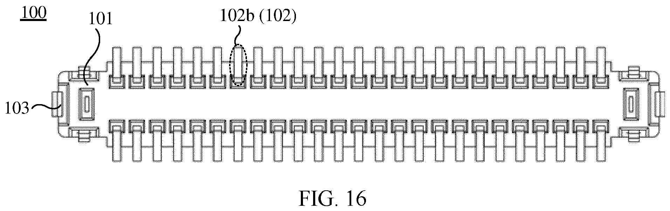

In a related technology, a connector 10 includes a male connector 100 and a connector holder 200. FIG. 16 is a diagram that is of a structure of the male connector 100 and that is seen from the mounting side according to the related technology. Refer to FIG. 16. The main structure of the male connector 100 in the connector 10 provided in the related technology includes a male housing 101, a plurality of male contact parts 102, and a pair of male fixed pins 103. The male contact part 102 includes a male contact terminal 102a and a male pin 102b electrically connected to the male contact terminal 102a. Sizes of the plurality of male contact parts 102 are the same. To be specific, sizes of a plurality of male contact terminals 102a are the same, and sizes of a plurality of male pins 102b are the same.

In the related technology, when a first electronic component 20 electrically connected to the male connector 100 is a circuit board, a structure of the circuit board electrically connected to the male connector 100 is the same as the structure of the second circuit board 400. Refer to FIG. 14 and the foregoing descriptions of the second circuit board 400. Details are not described herein again.

Based on this, when the first electronic component 20 electrically connected to the male connector 100 is the circuit board, the plurality of male pins 102b in the male connector 100 are connected to a plurality of pads on the circuit board in a one-to-one correspondence.

A structure of the connector holder 200 provided in the related technology is the same as the structure of the connector holder 200 provided in Embodiment 1. For the structure of the connector holder 200 provided in the related technology, refer to the foregoing descriptions, FIG. 11, and FIG. 12. Details are not described herein again. In addition, in the related technology, when a second electronic component 30 electrically connected to the connector holder 200 is a circuit board, a structure of the circuit board electrically connected to the connector holder 200 is the same as the structure of the second circuit board 400. Refer to FIG. 14 and the foregoing descriptions of the second circuit board 400. Details are not described herein again.

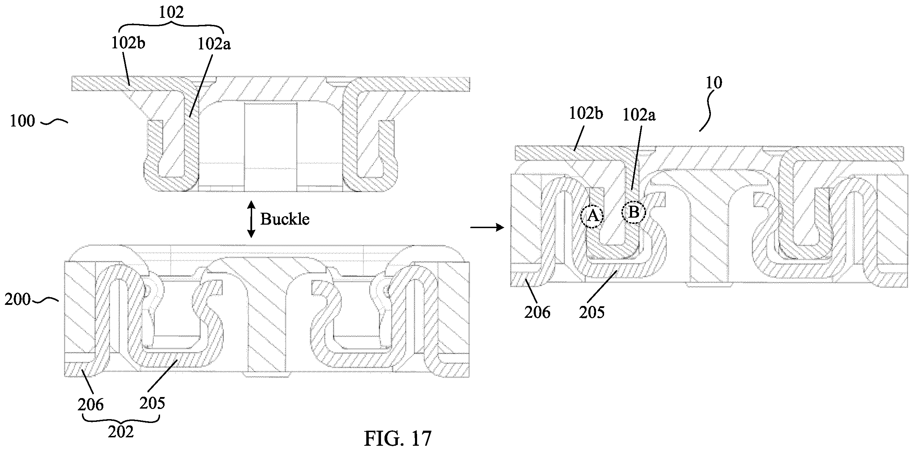

In addition, FIG. 17 shows a structure of the male connector 100 and the connector holder 200 in the connector 10 provided in the related technology when the male connector 100 is connected to the connector holder 200 through buckling. Refer to FIG. 17. The male contact terminal 102a of the male connector 100 and a holder contact terminal 205 of the connector holder 200 are electrically connected by using two contact points (for example, a contact point A and a contact point B in FIG. 17).

Based on the foregoing descriptions of the related technology, it can be learned that, in the related technology, the sizes of the plurality of male pins 102b of the male connector 100 are the same, and sizes of the pads that are on the circuit board and that are electrically connected to the plurality of male pins 102b of the male connector 100 in a one-to-one correspondence are the same. As a result, in the related technology, a relative area between a reference ground layer and both the male pin 102b and the pad is large, resulting in a large parasitic capacitance between the male connector 100 and the circuit board, and further resulting in small characteristic impedance of the male connector 100. In this case, a problem that the characteristic impedance of the male connector 100 does not match characteristic impedance of wiring on the circuit board electrically connected to the male connector 100 is caused. Consequently, a signal is reflected in a transmission process, and a problem of poor SI is caused. Similarly, in the related technology, the sizes of the plurality of holder pins 206 of the connector holder 200 are the same, and sizes of the pads that are on the circuit board and that are electrically connected to the plurality of holder pins 206 of the connector holder 200 in a one-to-one correspondence are the same. As a result, in the related technology, a relative area between the reference ground layer and both the holder pin 206 and the pad is large, resulting in a large parasitic capacitance between the connector holder 200 and the circuit board, and further resulting in small characteristic impedance of the connector holder 200. In this case, a problem that the characteristic impedance of the connector holder 200 does not match characteristic impedance of wiring on the circuit board electrically connected to the connector holder 200 is caused.

Consequently, the signal is reflected in the transmission process, and the problem of poor SI is caused. Based on this, a problem that characteristic impedance of the connector 10 does not match the characteristic impedance of the wiring on the two circuit boards that are electrically connected to the connector 10 may be caused. Consequently, the signal is reflected in the transmission process, and the problem of poor SI is caused.

Because the wiring on the circuit board is complex, after the circuit board is designed, the characteristic impedance of the wiring on the circuit board is difficult to adjust. To match the characteristic impedance of the connector 10 with the characteristic impedance of the wiring on the circuit board, the characteristic impedance of the connector 10 may be adjusted to match the characteristic impedance of the wiring on the circuit board, so as to reduce reflection of the signal during transmission, and improve the problem of poor SI. It can be learned from the foregoing characteristic impedance calculation formula that characteristic impedance may be adjusted by using a parasitic capacitance, and it can be learned from the foregoing capacitance calculation formula that a capacitance may be changed by adjusting ε, S, and d.

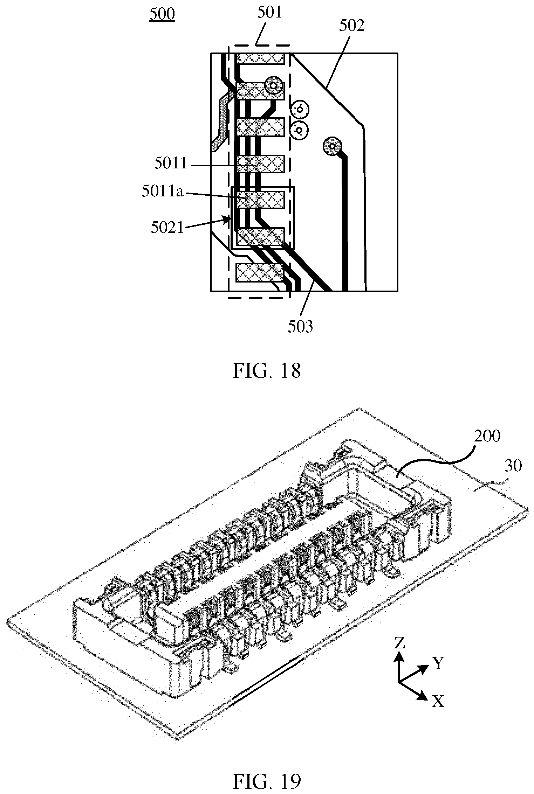

Using the male connector 100 and the circuit board electrically connected to the male connector 100 as an example, if the capacitance is changed by changing d, the reference ground layer in the circuit board needs to be hollowed. For example, FIG. 18 shows the circuit board electrically connected to the male connector 100, and the circuit board is referred to as a third circuit board 500 below for ease of distinguishing from another circuit board in embodiments of this application. Refer to FIG. 18. The third circuit board 500 includes a signal terminal layer, a reference ground layer, and a signal line layer that are sequentially disposed in a stacked manner. To distinguish the signal terminal layer, the reference ground layer, and the signal line layer in the third circuit board 500 from a signal terminal layer, a reference ground layer, and a signal line layer in another circuit board in embodiments of this application, the signal terminal layer in the third circuit board 500 is referred to as a third signal terminal layer 501, the reference ground layer in the third circuit board 500 is referred to as a third reference ground layer 502, and the signal line layer in the third circuit board 500 is referred to as a third signal line layer 503. The third signal terminal layer 501 includes a plurality of fourth pads 5011, and sizes of the plurality of fourth pads 5011 are the same. After the third reference ground layer 502 is hollowed, as shown in FIG. 18, the third reference ground layer 502 includes a hollow area 5021, and the hollow area 5021 covers a part of the fourth pads 5011 at the third signal terminal layer 501. For ease of description, the fourth pad 5011 covered by the hollow area 5021 is represented by a fourth pad 5011a. When a welding surface of a connector pin 105 of the male connector 100 is welded on a welding surface of the fourth pad 5011 of the third circuit board 500, because a part of the fourth pad 5011a facing the third reference ground layer 502 is hollowed out, a parasitic capacitance is not generated between the third reference ground layer 502 and both the male pin 102b and the fourth pad 5011a, but a parasitic capacitance is generated between the third signal line layer 503 below the third reference ground layer 502 and both the male pin 102b and the fourth pad 5011a. Because a distance between the fourth pad 5011a and the third signal line layer 503 is greater than a distance between the fourth pad 5011a and the third reference ground layer 502, the parasitic capacitance between the fourth pad 5011a and the third signal line layer 503 is less than the parasitic capacitance between the fourth pad 5011a and the third reference ground layer 502. Based on this, the reference ground layer of the circuit board is hollowed, so that the parasitic capacitance between the male connector 100 and the circuit board may also be reduced, to improve the characteristic impedance of the male connector 100.

However, after the reference ground layer is hollowed, because a part that is of the third signal line layer 503 and that directly faces the hollow area 5021 of the third reference ground layer 502 is not shielded by the third reference ground layer 502, a signal at the third signal line layer 503 may be radiated, and an interference problem may be caused. However, if there is no wiring in an area covered by the hollow area 5021 of the third reference ground layer 502, another area needs to be occupied for wiring. As a result, board-level wiring space is reduced, cabling is affected, and costs of manufacturing the circuit board are increased.

In Embodiment 1, the parasitic capacitance between the male connector 100 and the first circuit board 300 is changed by changing S. To be specific, because the area of the welding surface of the first male pin 1042 in the male connector 100 is reduced, and the area of the welding surface of the first male pad 3011 that is on the first circuit board 300 and that is electrically connected to the first male pin 1042 of the male connector 100 is reduced, when the male connector 100 is electrically connected to the first circuit board 300, a parasitic capacitance between the male connector 100 at the position of the first male pin 1042 and the first circuit board 300 is reduced, so that the characteristic impedance of the male connector 100 at the position of the first male pin 1042 may be increased. Therefore, the characteristic impedance of the male connector 100 at the position of the first male pin 1042 matches the characteristic impedance of the wiring on the first circuit board 300, to reduce reflection that is of a signal on the first male pin 1042 and that is caused when the signal is transmitted between the male connector 100 and the first circuit board 300, and improve SI. In comparison with the foregoing manner of changing the parasitic capacitance between the male connector 100 and the first circuit board 300 by changing d, in Embodiment 1, the parasitic capacitance between the male connector 100 at the position of the first male pin 1042 and the first circuit board 300 is changed by changing S, so that no signal radiation is caused, and costs are not increased.

In Embodiment 1, a material of the first insulation layer between the first signal terminal layer 301 and the first reference ground layer 302 on the first circuit board 300 may alternatively be adjusted to adjust ε, so as to change the parasitic capacitance between the male connector 100 and the first circuit board 300. In some examples, to make the parasitic capacitance between the male connector 100 and the first circuit board 300 small, a selected material of the first insulation layer needs to have a low dielectric constant.

Based on this, a material between two adjacent male contact terminals may alternatively be adjusted to adjust ε, so as to change a parasitic capacitance between the two adjacent male contact terminals. Because the male contact part 102 is mounted on the male housing 101, a material of the male housing 101 may alternatively be adjusted to adjust ε, so as to change the parasitic capacitance between the two adjacent male contact terminals. In some examples, to reduce the parasitic capacitance between the two adjacent male contact terminals, a selected male housing 101 needs to have a low dielectric constant.

The following provides a specific example, and simulation is separately performed on the connector 10 provided in Embodiment 1, the first electronic component 20 and the second electronic component 30 that are electrically connected to the connector 10 provided in Embodiment 1, the connector 10 provided in the related technology, and the first electronic component 20 and the second electronic component 30 that are electrically connected to the connector 10 provided in the related technology, to detect and compare the characteristic impedance of the connectors 10 provided in Embodiment 1 and the related technology, and quality of signals transmitted by using the connectors 10. The signal quality may be represented by an insertion loss and a return loss, and a simulation result is shown in Table 1.

It should be noted that, during simulation, the first male pin 1042 in the connector 10 provided in Embodiment 1 is a high-speed signal pin. During simulation, an example in which the first electronic component 20 is a PCB and the second electronic component 30 is an FPC is used.

A structure of the PCB for simulation mainly includes a first coverage layer (cover lay), a first copper foil (copper) layer, a polypropylene (polypropylene, PP) layer, a second copper foil layer, and a second coverage layer that are sequentially stacked. A thickness of the first coverage layer is 25 μm, a thickness of the first copper foil layer is 20 μm, a thickness of the polypropylene layer is 76 μm, a thickness of the second copper foil layer is 15 μm, and a thickness of the second coverage layer is 25 μm. A dielectric constant DK of the polypropylene layer is 3.5, and a dielectric loss angle coefficient DF is 0.02. The first coverage layer and the second coverage layer are configured to protect the PCB. The first copper foil layer is a signal terminal layer, and the first copper foil layer includes a plurality of pads. The second copper foil layer is a reference ground layer. A difference between a PCB electrically connected to the male connector 100 of the connector 10 provided in Embodiment 1 and a PCB electrically connected to the male connector 100 of the connector 10 provided in the related technology is that a structure of the first copper foil layer of the PCB electrically connected to the male connector 100 of the connector 10 provided in Embodiment 1 is different from a structure of the first copper foil layer of the PCB electrically connected to the male connector 100 of the connector 10 provided in the related technology. For details, refer to the foregoing descriptions. Structures of other layers are all the same.

A structure of the FPC for simulation mainly includes a third coverage layer, a third copper foil layer, a polyimide (polyimide, PI) layer, a fourth copper foil layer, and a fourth coverage layer that are sequentially stacked. A thickness of the first coverage layer is 20 μm, a thickness of the first copper foil layer is 12 μm, a thickness of the polyimide layer is 50 μm, a thickness of the second copper foil layer is 12 μm, and a thickness of the second coverage layer is 20 μm. A dielectric constant DK of the polyimide layer is 3.3, and a dielectric loss angle coefficient DF is 0.02. The third coverage layer and the fourth coverage layer are configured to protect the FPC. The third copper foil layer is a signal terminal layer, and the third copper foil layer includes a plurality of pads. The fourth copper foil layer is a reference ground layer. A structure of an FPC electrically connected to the connector holder 200 of the connector 10 provided in Embodiment 1 is completely the same as a structure of an FPC electrically connected to the connector holder 200 of the connector 10 provided in the related technology.

Herein, characteristic impedance of wiring on the PCB for simulation and characteristic impedance of wiring on the FPC for simulation are about 90 Ω (ohm).

In addition, in a simulation process, the characteristic impedance of the connector 10 may be measured by using a TDR (time domain reflectometry, time domain reflectometry) method.

In addition, to ensure accuracy of a detection result, in Table 1, an insertion loss and a return loss are detected when a frequency is 5 GHz and when a frequency is 10 GHz separately.

**Table 1**

|  | Characteristic impedance (ohm) | Insertion loss (dB) | | Return loss (dB) | |
|---|---|---|---|---|---|
|  |  | 5 GHz | 10 GHz | 5GHz | 10 GHz |
| Objective | 76 to 94 |  |  | -20 | -15 |
| Related Technology | 75 | -0.21 | -0.42 | -17.4 | -14 |

(continued)

|  | Characteristic impedance (ohm) | Insertion loss (dB) | | Return loss (dB) | |
| --- | --- | --- | --- | --- | --- |
|  |  | 5 GHz | 10 GHz | 5GHz | 10 GHz |
| Embodiment 1 | 82.3 | -0.14 | -0.25 | -21.6 | -20.6 |
| Benefits | 7.3 | 0.07 | 0.17 | -4.2 | -6.6 |

It can be learned by comparing data in Table 1 that, in comparison with those of the connector 10 provided in the related technology, characteristic impedance, an insertion loss, and a return loss of the connector 10 provided in Embodiment 1 are improved. In comparison with those of the connector 10 provided in the related technology, the characteristic impedance of the connector 10 provided in Embodiment 1 increases by 7.3 ohms. When the frequency is 5 GHz, the insertion loss increases by 0.07, and the return loss increases by -4.2. When the frequency is 105 GHz, the insertion loss increases by 0.17, and the return loss increases by -6.6. It can be learned through comparison that, in comparison with the connector 10 provided in the related technology, the connector 10 provided in Embodiment 1 brings an obvious benefit to a high-speed signal.

**Embodiment 2**

A difference between Embodiment 2 and Embodiment 1 is that structures of a connector holder 200 provided in Embodiment 2 and a second electronic component 30 electrically connected to the connector holder 200 are different from the structures of the connector holder 200 provided in Embodiment 1 and the second electronic component 30 electrically connected to the connector holder 200.

Structures of a male connector 100 provided in Embodiment 2 and a first electronic component 20 electrically connected to the male connector 100 are the same as the structures of the male connector 100 provided in Embodiment 1 and the first electronic component 20 electrically connected to the male connector 100. The male connector 100 provided in Embodiment 2 includes a male housing 101, a plurality of male contact parts 102, and a pair of male fixed pins 103. The plurality of male contact parts 102 include a plurality of first male contact parts 104 and a plurality of second male contact parts 105. Each first male contact part 104 includes a first male contact terminal 1041 and a first male pin 1042 electrically connected to the first male contact terminal 1041. Each second male contact part 105 includes a second male contact terminal 1051 and a second male pin 1052 electrically connected to the second male contact terminal 1051. An area of a welding surface of the first male pin 1042 is less than an area of a welding surface of the second male pin 1052.

The first electronic component 20 provided in Embodiment 2 is a first circuit board 300. The first circuit board 300 includes a first signal terminal layer 301, a first reference ground layer 302, and a first signal line layer 303 that are sequentially disposed in a stacked manner. The first signal terminal layer 301 includes a first male pad 3011 and a second male pad 3012. An area of a welding surface of the first male pad 3011 is less than an area of a welding surface of the second male pad 3012.

It should be noted that, for a connection relationship between the male connector 100 and the first electronic component 20, descriptions of a specific structure of the male connector 100, and descriptions of a specific structure of the first circuit board 300, refer to Embodiment 1. Details are not described herein again.

In addition, because the structures of the male connector 100 provided in Embodiment 2 and the first electronic component 20 electrically connected to the male connector 100 are the same as the structures of the male connector 100 provided in Embodiment 1 and the first electronic component 20 electrically connected to the male connector 100, the male connector 100 and the first electronic component 20 provided in Embodiment 2 have the same technical effects as the male connector 100 and the first electronic component 20 provided in Embodiment 1. Refer to Embodiment 1. Details are not described herein again.

The following describes the structures of the connector holder 200 provided in Embodiment 2 and the second electronic component 30 electrically connected to the connector holder 200.

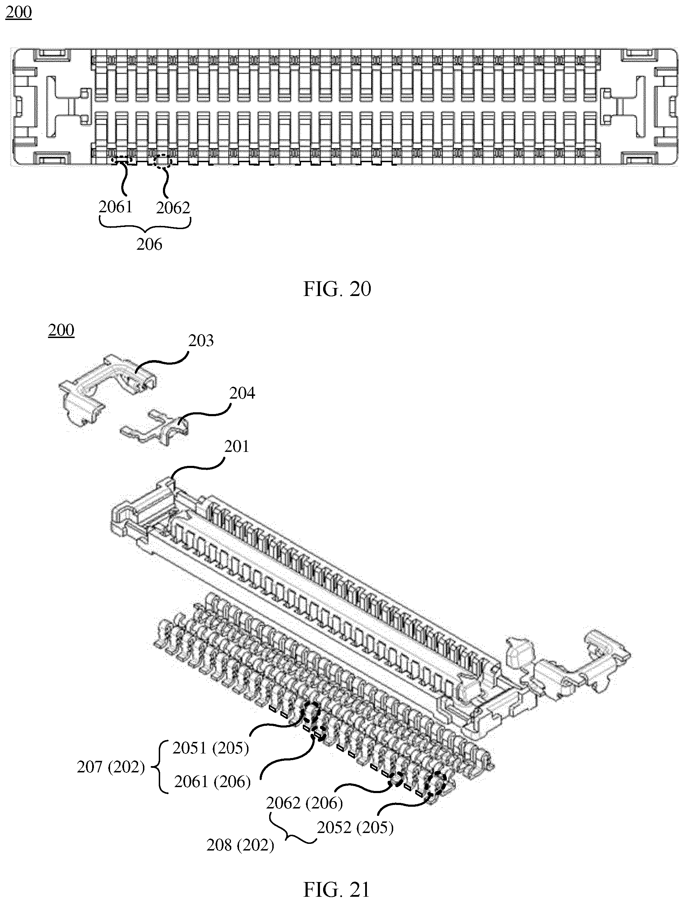

FIG. 19 is a three-dimensional diagram of the connector holder 200 mounted on the second electronic component 30. For example, the second electronic component 30 in FIG. 19 is a circuit board. FIG. 20 is a diagram that is of a structure of the connector holder 200 and that is seen from the mounting side. FIG. 21 is an exploded view of the connector holder 200. FIG. 21 is an exploded view that is of the connector holder 200 and that is seen from the mounting side. As shown in FIG. 21, the connector holder 200 includes a holder housing 201, a plurality of holder contact parts 202, a pair of holder fixed pins 203, and a pair of holder middle islands 204.

As shown in FIG. 21, the plurality of holder contact parts 202 include a plurality of first contact parts and a plurality of second contact parts. To distinguish from a first contact part and a second contact part in the male connector 100, the first contact part in the connector holder 200 is referred to as a first holder contact part 207, and the second contact part in the connector holder 200 is referred to as a second holder contact part 208.

Structures of the first holder contact part 207 and the second holder contact part 208 in Embodiment 2 are similar to the structure of the holder contact part 202 in Embodiment 1. For the structures of the first holder contact part 207 and the second holder contact part 208 in Embodiment 2, refer to FIG. 13.

Refer to FIG. 13. The first holder contact part 207 includes a first contact terminal and a first pin electrically connected to the first contact terminal. To distinguish the first contact terminal and the first pin in the connector holder 200 from a first contact terminal and a first pin in the male connector 100, the first contact terminal in the first holder contact part 207 is referred to as a first holder contact terminal 2051, and the first pin in the first holder contact part 207 is referred to as a first holder pin 2061. The first holder contact terminal 2051 and the first holder pin 2061 electrically connected to the first holder contact terminal 2051 are integrally formed. Each second holder contact part 208 includes a second contact terminal and a second pin electrically connected to the second contact terminal. To distinguish the second contact terminal and the second pin in the connector holder 200 from a second contact terminal and a second pin in the male connector 100, the second contact terminal in the second holder contact part 208 is referred to as a second holder contact terminal 2052, and the second pin in the second holder contact part 208 is referred to as a second holder pin 2062. The second holder contact terminal 2052 and the second holder pin 2062 electrically connected to the second holder contact terminal 2052 are integrally formed. To be specific, the plurality of holder contact terminals 205 in the connector holder 200 include a plurality of first holder contact terminals 2051 and a plurality of second holder contact terminals 2052, and the plurality of holder pins 206 in the connector holder 200 include a plurality of first holder pins 2061 and a plurality of second holder pins 2062.

Herein, the first holder pin 2061, the second holder pin 2062, and the second electronic component 30 may be electrically connected through welding.

In addition, for functions of the first holder contact terminal 2051, the second holder contact terminal 2052, the first holder pin 2061, the second holder pin 2062, and the holder fixed pin 203, refer to Embodiment 1. Details are not described herein again.

In addition, because the first holder contact part 207 includes the first holder contact terminal 2051 and the first holder pin 2061 electrically connected to the first holder contact terminal 2051, and the second holder contact part 208 includes the second holder contact terminal 2052 and the second holder pin 2062 electrically connected to the second holder contact terminal 2052, quantities and arrangement manners of the first holder contact part 207, the first holder contact terminal 2051, and the first holder pin 2061 are completely the same, and quantities and arrangement manners of the second holder contact part 208, the second holder contact terminal 2052, and the second holder pin 2062 are completely the same. The first holder contact part 207 and the second holder contact part 208 are used as an example to describe an arrangement manner of the first holder contact part 207, the first holder contact terminal 2051, the first holder pin 2061, the second holder contact part 208, the second holder contact terminal 2052, and the second holder pin 2062. The plurality of first holder contact parts 207 and the plurality of second holder contact parts 208 may be sequentially arranged on one side of the connector holder 200 along a length direction (namely, a Y direction in FIG. 21) of the connector holder 200. The plurality of first holder contact parts 207 and the plurality of second holder contact parts 208 may alternatively be sequentially arranged on two opposite sides of the connector holder 200 along the length direction of the connector holder 200.

Refer to FIG. 20 and FIG. 21. In this embodiment, an area of a welding surface of the first holder pin 2061 is less than an area of a welding surface of the second holder pin 2062.

It should be noted that a value range of the area of the welding surface of the first holder pin 2061 may be the same as the value range of the area of the welding surface of the first male pin 1042. Refer to the foregoing descriptions. Details are not described herein again.

A value range of the area of the welding surface of the second holder pin 2062 may be the same as the value range of the area of the welding surface of the second male pin 1052. Refer to the foregoing descriptions. Details are not described herein again.

A range of a difference between the area of the welding surface of the second holder pin 2062 and the area of the welding surface of the first holder pin 2061 may be the same as the range of the difference between the area of the welding surface of the second male pin 1052 and the area of the welding surface of the first male pin 1042. Refer to the foregoing descriptions. Details are not described herein again.

When the area of the welding surface of the first holder pin 2061 is less than the area of the welding surface of the second holder pin 2062, in some examples, the first holder pin 2061 and the second holder pin 2062 are arranged along the length direction of the connector holder 200. Along the width direction of the connector holder 200, a length of the welding surface of the first holder pin 2061 is less than a length of the welding surface of the second holder pin 2062.

It should be noted that, a value range of the length of the welding surface of the first holder pin 2061 along the width direction of the connector holder 200 may be the same as the value range of the length of the welding surface of the first male pin 1042 along the width direction of the male connector 100. Refer to the foregoing descriptions. Details are not described herein again.

A value range of the length of the welding surface of the second holder pin 2062 along the width direction of the connector holder 200 may be the same as the value range of the length of the welding surface of the second male pin 1052 along the width direction of the male connector 100. Refer to the foregoing descriptions. Details are not described herein again.

A range of a difference between the length of the welding surface of the second holder pin 2062 and the length of the welding surface of the first holder pin 2061 along the width direction of the connector holder 200 may be the same as the range of the difference between the length of the welding surface of the second male pin 1052 and the length of the welding surface of the first male pin 1042 along the width direction of the male connector 100. Refer to the foregoing descriptions. Details are not described herein again.

Based on this, along the length direction of the connector holder 200, a width of the welding surface of the first holder pin 2061 may be the same as or different from a width of the welding surface of the second holder pin 2062.

A value range of the width of the welding surface of the first holder pin 2061 along the width direction of the connector holder 200 may be the same as the value range of the width of the welding surface of the first male pin 1042 along the width direction of the male connector 100. Refer to the foregoing descriptions. Details are not described herein again.

A value range of the width of the welding surface of the second holder pin 2062 along the width direction of the connector holder 200 may be the same as the value range of the width of the welding surface of the second male pin 1052 along the width direction of the male connector 100. Refer to the foregoing descriptions. Details are not described herein again.

A range of a difference between the width of the welding surface of the second holder pin 2062 and the width of the welding surface of the first holder pin 2061 along the width direction of the connector holder 200 may be the same as the range of the difference between the width of the welding surface of the second male pin 1052 and the width of the welding surface of the first male pin 1042 along the width direction of the male connector 100. Refer to the foregoing descriptions. Details are not described herein again.

It should be noted that, during appearance inspection, to detect a welding status between the holder pin 206 and the second electronic component 30, all the holder pins 206 need to be visible. Because the plurality of holder pins 206 of the connector holder 200 include the first connector holder 2061 and the second holder pin 2062, when the length of the welding surface of the first holder pin 2061 is small along the width direction of the connector holder 200, to ensure that the first holder pin 2061 is visible, a part that is of the holder housing 201 and that is located at the first holder pin 2061 may be synchronously retracted with the first holder pin 2061, to ensure that all the first holder pins 2061 and second holder pins 2062 are visible, so as to facilitate quality check after welding.

Based on the foregoing connection relationship, both an arrangement manner of the first holder contact terminal 2051 and the second holder contact terminal 2052 in the connector holder 200 and an arrangement manner of the first holder pin 2061 and the second holder pin 2062 in the connector holder 200 are the same as the arrangement manner of the first male pin 1042 and the second male pin 1052 in the male connector 100. For details, refer to the arrangement manner of the first male pin 1042 and the second male pin 1052 in the male connector 100. Details are not described herein again.

Based on the foregoing connector holder 200, in this embodiment, the second electronic component 30 electrically connected to the connector holder 200 is a circuit board, and is referred to as a fourth circuit board below for ease of distinguishing from another circuit board in embodiments of this application. The fourth circuit board may be, for example, a PCB or an FPC.

Herein, a structure of the fourth circuit board is similar to the structure of the first circuit board 300. As shown in FIG. 8, a fourth circuit board 600 includes a signal terminal layer, a reference ground layer, and a signal line layer that are sequentially disposed in a stacked manner. To distinguish the signal terminal layer, the reference ground layer, and the signal line layer in the fourth circuit board 600 from a signal terminal layer, a reference ground layer, and a signal line layer in another circuit board in embodiments of this application, the signal terminal layer in the fourth circuit board 600 is referred to as a fourth signal terminal layer 601, the reference ground layer in the fourth circuit board 600 is referred to as a fourth reference ground layer 602, and the signal line layer in the fourth circuit board 600 is referred to as a fourth signal line layer 603. The fourth reference ground layer 602 covers the fourth signal terminal layer 601. Because the fourth reference ground layer 602 covers the fourth signal terminal layer 601, mutual interference between the fourth signal terminal layer 601 and the fourth signal line layer 603 can be avoided. The fourth signal terminal layer 601 includes a plurality of pads.

It should be understood that, to separate the fourth signal terminal layer 601 from the fourth reference ground layer 602, the fourth circuit board 600 further includes a fifth insulation layer disposed between the fourth signal terminal layer 601 and the fourth reference ground layer 602. Similarly, to separate the fourth reference ground layer 6022 from the fourth signal line layer 603, the fourth circuit board 600 further includes a sixth insulation layer disposed between the fourth reference ground layer 602 and the fourth signal line layer 603. The fifth insulation layer and the sixth insulation layer are not shown in FIG. 8.

It may be understood that a size of a pad on the fourth circuit board 600 is designed based on a size of a pin welded on the pad. When the connector holder 200 is mounted on the fourth circuit board 600, the holder pin 206 of the connector holder 200 is welded on the pad on the fourth circuit board 600, to implement an electrical connection between the connector holder 200 and the fourth circuit board 600. The connector holder 200 in this embodiment includes the first holder pin 2061 and the second holder pin 2062, and the area of the welding surface of the first holder pin 2061 is less than the area of the welding surface of the second holder pin 2062. Therefore, the plurality of pads of the fourth signal terminal layer 601 in this embodiment include a first pad and a second pad. To distinguish the first pad and the second pad that are on the fourth circuit board 600 electrically connected to the connector holder 200 from the first pad and the second pad that are on the first circuit board 300 electrically connected to the male connector 100, the first pad on the fourth circuit board 600 electrically connected to the connector holder 200 is referred to as a first holder pad 6011, and the second pad on the fourth circuit board 600 electrically connected to the connector holder 200 is referred to as a second holder pad 6012. An area of a welding surface of the first holder pad 6011 is less than an area of a welding surface of the second holder pad 6012.

It should be noted that a value range of the area of the welding surface of the first holder pad 6011 may be the same as the value range of the area of the welding surface of the first male pad 3011. Refer to the foregoing value range of the area of the welding surface of the first male pad 3011. Details are not described herein again.

A value range of the area of the welding surface of the second holder pad 6012 may be the same as the value range of the area of the welding surface of the second male pad 3012. Refer to the foregoing value range of the area of the welding surface of the second male pad 3012. Details are not described herein again.

A range of a difference between the area of the welding surface of the second holder pad 6012 and the area of the welding surface of the first holder pad 6011 may be the same as the range of the difference between the area of the welding surface of the second male pad 3012 and the area of the welding surface of the first male pad 3011. Refer to the foregoing descriptions. Details are not described herein again.

When the second electronic component 30 is the fourth circuit board 600, and the connector holder 200 is mounted on the second electronic component 30, the welding surface of the first holder pin 2061 of the connector holder 200 is welded on the welding surface of the first holder pad 6011 of the fourth circuit board 600, and the welding surface of the second holder pin 2062 of the connector holder 200 is welded on the welding surface of the second holder pad 6012 of the fourth circuit board 600, to implement the electrical connection between the connector holder 200 and the fourth circuit board 600.

When the area of the welding surface of the first holder pad 6011 is less than the area of the welding surface of the second holder pad 6012, in some examples, the first holder pad 6011 and the second holder pad 6012 are arranged along a first direction. Along a direction perpendicular to the first direction, a length of the welding surface of the first holder pad 6011 is less than a length of the welding surface of the second holder pad 6012.

It should be noted that, a value range of the length of the welding surface of the first holder pad 6011 along the direction perpendicular to the first direction may be the same as the value range of the length of the welding surface of the first male pad 3011 along the direction perpendicular to the first direction. Refer to the foregoing descriptions. Details are not described herein again.

A value range of the length of the welding surface of the second holder pad 6012 along the direction perpendicular to the first direction may be the same as the value range of the length of the welding surface of the second male pad 3012 along the direction perpendicular to the first direction. Refer to the foregoing descriptions. Details are not described herein again.

A range of a difference between the length of the welding surface of the second holder pad 6012 and the length of the welding surface of the first holder pad 6011 along the direction perpendicular to the first direction may be the same as the range of the difference between the length of the welding surface of the second male pad 3012 and the length of the welding surface of the first male pad 3011. Refer to the foregoing descriptions. Details are not described herein again.

Based on this, along the first direction, a width of the welding surface of the first holder pad 6011 may be the same as or different from a width of the welding surface of the second holder pad 6012.

A value range of the width of the welding surface of the first holder pad 6011 along the first direction may be the same as the value range of the width of the welding surface of the first male pad 3011. Refer to the foregoing descriptions. Details are not described herein again.

A value range of the width of the welding surface of the second holder pad 6012 along the first direction may be the same as the value range of the width of the welding surface of the second male pad 3012. Refer to the foregoing descriptions. Details are not described herein again.

A range of a difference between the width of the welding surface of the second holder pad 6012 and the width of the welding surface of the first holder pad 6011 along the first direction may be the same as the range of the difference between the width of the welding surface of the second male pad 3012 and the width of the welding surface of the first male pad 3011. Refer to the foregoing descriptions. Details are not described herein again.

In this embodiment, when the connector holder 200 is mounted on the fourth circuit board 600, because the area of the welding surface of the first holder pin 2061 of the connector holder 200 is less than the area of the welding surface of the second holder pin 2062, the area of the welding surface of the first holder pad 6011 of the fourth circuit board 600 is less than the area of the welding surface of the second holder pad 6012, the welding surface of the first holder pin 2061 is welded on the welding surface of the first holder pad 6011, and the welding surface of the second holder pin 2062 is welded on the welding surface of the second holder pad 6012, a relative area between the fourth reference ground layer 602 of the fourth circuit board 600 and both the first holder pin 2061 and the first holder pad 6011 is less than a relative area between the fourth reference ground layer 602 of the fourth circuit board 600 and both the second holder pin 2062 and the second holder pad 6012. It can be learned based on a capacitance formula that a parasitic capacitance between the fourth reference ground layer 602 of the fourth circuit board 600 and both the first holder pin 2061 and the first holder pad 6011 is less in comparison with a parasitic capacitance between the fourth reference ground layer 602 of the fourth circuit board 600 and both the second holder pin 2062 and the second holder pad 6012. Therefore, it can be learned based on the characteristic impedance calculation formula that, characteristic impedance of the connector holder 200 at a position of the first holder pin 2061 increases. In this way, a problem that the characteristic impedance of the connector holder 200 at the position of the first holder pin 2061 does not match the characteristic impedance of the wiring on the fourth circuit board 600 can be improved, reflection that is of a signal on the first holder pin 2061 and that is caused when the signal is transmitted between the connector holder 200 and the fourth circuit board 600 is reduced, and SI is improved.

Based on this, in this embodiment, when the characteristic impedance of the connector holder 200 at the position of the first holder pin 2061 is increased, because the area of the welding surface of the second holder pin 2062 and the area of the welding surface of the second holder pad 6012 are large, the welding surface of the second holder pin 2062 may be welded on the welding surface of the second holder pad 6012, so that a welding force between the connector holder 200 and the fourth circuit board 600 is large, to ensure that the connector holder 200 and the fourth circuit board 600 are firmly connected.

It should be noted that, if a bonding force between the connector holder 200 and the fourth circuit board 600 is insufficient, the length and/or the width of the welding surface of the second holder pin 2062 may be further increased, to ensure that a welding force between the holder pin 206 of the connector holder 200 and the fourth circuit board 600 satisfies a requirement.

It should be understood that, because the connector holder 200 includes a plurality of holder contact terminals 205 arranged along the length direction of the connector holder 200, a parasitic capacitance may also be generated between two adjacent holder contact terminals 205. The parasitic capacitance also affects the characteristic impedance of the connector holder 200. When the connector holder 200 is connected to the male connector 100 through buckling, the holder contact terminal 205 needs to contact the male contact terminal 104. If areas of sections that are of all the holder contact terminals 205 and that are along the width direction of the connector holder 200 are reduced, a buckling force may be insufficient when the connector holder 200 is connected to the male connector 100 through buckling. As a result, buckling reliability between the male connector 100 and the connector holder 200 may be affected.

Based on this, in this embodiment, areas of sections that are of a part of the holder contact terminals 205 and that are along the width direction of the connector holder 200 may be reduced, so that the parasitic capacitance between two adjacent holder contact terminals 205 can be reduced, and the buckling reliability between the male connector 100 and the connector holder 200 can be ensured.

In some examples, an area of a section that is of the first holder contact terminal 2051 and that is along the width direction of the connector holder 200 is less than an area of a section that is of the second holder contact terminal 2052 and that is along the width direction of the connector holder 200.

Because the area of the section that is of the first holder contact terminal 2051 and that is along the width direction of the connector holder 200 is less than the area of the section that is of the second holder contact terminal 2052 and that is along the width direction of the connector holder 200, a parasitic capacitance between the first holder contact terminal 2051 and the holder contact terminal 205 adjacent to the first holder contact terminal 2051 is small. Therefore, characteristic impedance at a position of the first holder contact terminal 2051 is large. In this way, a problem that the connector holder 200 at the position of the first holder contact terminal 2051 does not match the characteristic impedance of the wiring on the fourth circuit board 400 can be improved, reflection that is of a signal in the first holder contact terminal 2051 and that is caused when the signal is transmitted between the connector holder 200 and the fourth circuit board 400 is reduced, and the SI is improved. Because the first holder pin 2061 is electrically connected to the first holder contact terminal 2051, the reflection that is of the signal on the first holder pin 2061 and that is caused when the signal is transmitted between the connector holder 200 and the fourth circuit board 600 can also be further reduced.

In Embodiment 2, a material of the fifth insulation layer between the fourth signal terminal layer 601 and the fourth reference ground layer 602 on the fourth circuit board 600 may alternatively be adjusted to adjust ε, so as to change the parasitic capacitance between the connector holder 200 and the fourth circuit board 600. In some examples, to make the parasitic capacitance between the connector holder 200 and the fourth circuit board 600 small, a selected material of the fifth insulation layer needs to have a low dielectric constant.

Based on this, a material between two adjacent holder contact terminals 205 may alternatively be adjusted to adjust ε, so as to change a parasitic capacitance between the two adjacent holder contact terminals 205. Because the holder contact part 202 is mounted on the holder housing 201, a material of the holder housing 201 may alternatively be adjusted to adjust ε, so as to change the parasitic capacitance between the two adjacent holder contact terminals 205. In some examples, to reduce the parasitic capacitance between the two adjacent holder contact terminals 205, a selected holder housing 201 needs to have a low dielectric constant.

Considering that integrity of a signal transmitted between the connector holder 200 and the fourth circuit board 600 is mainly related to a high-speed signal, based on this, in some examples, the first holder pin 2061 is a high-speed signal pin, and the second holder pin 2062 is a non-high-speed signal pin.

Herein, for the non-high-speed signal pin, refer to descriptions in Embodiment 1. Details are not described herein again.

It should be understood that, because the first holder pin 2061 is electrically connected to the first holder contact terminal 2051, and the welding surface of the first holder pin 2061 is welded on the welding surface of the first holder pad 6011, when the first holder pin 2061 is the high-speed signal pin, both the first holder contact terminal 2051 and the first holder pad 6011 transmit high-speed signals. Similarly, because the second holder pin 2062 is electrically connected to the second holder contact terminal 2052, and the welding surface of the second holder pin 2062 is welded on the welding surface of the second holder pad 6012, when the second holder pin 2062 is the non-high-speed signal pin, both the second holder contact terminal 2052 and the second holder pad 6012 transmit non-high-speed signals.

Because the first holder pin 2061 is the high-speed signal pin, and the second holder pin 2062 is the non-high-speed signal pin, reflection caused when a high-speed signal is transmitted between the connector holder 200 and the fourth circuit board 600 may be reduced. Signal integrity mainly depends on the high-speed signal. In this way, the SI may be further improved.

In this embodiment, for a manner in which the male contact terminal 104 of the male connector 100 in the connector 10 is connected to the holder contact terminal 205 of the connector holder 200 through buckling, and a corresponding technical effect, refer to Embodiment 1. Details are not described herein again.

**Embodiment 3**

A difference between Embodiment 3 and Embodiment 2 is that structures of a male connector 100 provided in Embodiment 3 and a first electronic component 20 electrically connected to the male connector 100 are different from the structures of the male connector 100 provided in Embodiment 2 and the first electronic component 20 electrically connected to the male connector 100.

Structures of a connector holder 200 provided in Embodiment 3 and a second electronic component 30 electrically connected to the connector holder 200 are the same as the structures of the connector holder 200 provided in Embodiment 2 and the second electronic component 30 electrically connected to the connector holder 200. Refer to FIG. 20 and FIG. 21. The connector holder 200 provided in Embodiment 3 includes a holder housing 201, a plurality of holder contact parts 202, a pair of holder fixed pins 203, and a pair of holder middle islands 204. The plurality of holder contact parts 202 include a plurality of first holder contact parts 207 and a plurality of second holder contact parts 208. The first holder contact part 207 includes a first holder contact terminal 2051 and a first holder pin 2061 electrically connected to the first holder contact terminal 2051, and the first holder contact terminal 2051 and the first holder pin 2061 electrically connected to the first holder contact terminal 2051 are integrally formed. The second holder contact part 208 includes a second holder contact terminal 2052 and a second holder pin 2062 electrically connected to the second holder contact terminal 2052, and the second holder contact terminal 2052 and the second holder pin 2062 electrically connected to the second holder contact terminal 2052 are integrally formed. An area of a welding surface of the first holder pin 2061 is less than an area of a welding surface of the second holder pin 2062.

Refer to FIG. 8. The second electronic component 30 provided in Embodiment 3 is a fourth circuit board 600. The fourth circuit board 600 includes a fourth signal terminal layer 601, a fourth reference ground layer 602, and a fourth signal line layer 603 that are sequentially disposed in a stacked manner. The fourth signal terminal layer 601 includes a first holder pad 6011 and a second holder pad 6012. An area of a welding surface of the first holder pad 6011 is less than an area of a welding surface of the second holder pad 6012.

It should be noted that, for a connection relationship between the connector holder 200 and the fourth circuit board 600, descriptions of a specific structure of the connector holder 200, and descriptions of a specific structure of the fourth circuit board 600, refer to Embodiment 2. Details are not described herein again.

In addition, because the structures of the connector holder 200 provided in Embodiment 3 and the second electronic component 30 electrically connected to the connector holder 200 are the same as the structures of the connector holder 200 provided in Embodiment 2 and the second electronic component 30 electrically connected to the connector holder 200, the connector holder 200 and the second electronic component 30 provided in Embodiment 3 have the same technical effects as the connector holder 200 and the second electronic component 30 provided in Embodiment 2. Refer to Embodiment 2. Details are not described herein again.

Structures of a male connector 100 provided in Embodiment 3 and a first electronic component 20 electrically connected to the male connector 100 are the same as the structures of the male connector 100 provided in the related technology and the first electronic component 20 electrically connected to the male connector 100. The main structure of the male connector 100 provided in Embodiment 3 includes a male housing 101, a plurality of male contact parts 102, and a pair of male fixed pins 103. The male contact part 102 includes a male contact terminal 102a and a male pin 102b electrically connected to the male contact terminal 102a. Sizes of the plurality of male contact parts 102 are the same. To be specific, sizes of a plurality of male contact terminals 102a are the same, and sizes of a plurality of male pins 102b are the same.

In some examples, a value range of an area of a welding surface of the male pin 102b is the same as the value range of the area of the welding surface of the second male pin 1052. Refer to the foregoing descriptions. Details are not described herein again.

In some examples, a value range of a length of the welding surface of the male pin 102b along the width direction of the male connector 100 is the same as the value range of the length of the welding surface of the second male pin 1052 along the width direction of the male connector 100. Refer to the foregoing descriptions. Details are not described herein again.

In some examples, a value range of a width of the welding surface of the male pin 102b along the length direction of the male connector 100 is the same as the value range of the width of the welding surface of the second male pin 1052 along the length direction of the male connector 100. Refer to the foregoing descriptions. Details are not described herein again. In Embodiment 3, when a first electronic component 20 electrically connected to the male connector 100 is a circuit board, a structure of the circuit board electrically connected to the male connector 100 is the same as the structure of the second circuit board 400. Refer to FIG. 14 and the foregoing descriptions of the second circuit board 400. Details are not described herein again. Based on this, when the first electronic component 20 electrically connected to the male connector 100 is a circuit board, for a connection relationship between the male connector 100 and the circuit board, refer to descriptions of the related technology in Embodiment 1. Details are not described herein again.

In this embodiment, the male contact terminal 104 of the male connector 100 in the connector 10 may be connected to the holder contact terminal 205 of the connector holder 200 through buckling by using a plurality of contact points (for example, two contact points), so that the male connector 100 is connected to the connector holder 200 through buckling.


**Embodiment 4**

A difference between Embodiment 4 and Embodiment 1, Embodiment 2, and Embodiment 3 is that, in Embodiment 1, the area of the welding surface of a part of the male pins (namely, the first male pin 1042) in the male connector 100 is reduced, and the area of the welding surface of a part of the pads (namely, the first male pad 3011) on the first circuit board 300 electrically connected to the male connector 100 is reduced. In Embodiment 2, the area of the welding surface of a part of the male pins (namely, the first male pin 1042) in the male connector 100 is reduced, the area of the welding surface of a part of the pads (namely, the first male pad 3011) on the first circuit board 300 electrically connected to the male connector 100 is reduced, the area of the welding surface of a part of the holder pins (namely, the first holder pin 2061) in the connector holder 200 is reduced, and the area of the welding surface of a part of the pads (namely, the first holder pad 6011) on the fourth circuit board 600 electrically connected to the connector holder 200 is reduced. In Embodiment 3, the area of the welding surface of a part of the holder pins (namely, the first holder pin 2061) in the connector holder 200 is reduced, and the area of the welding surface of a part of the pads (namely, the first holder pad 6011) on the fourth circuit board 600 electrically connected to the connector holder 200 is reduced.

However, in Embodiment 4, areas of welding surfaces of all male pins 102b in a male connector 100 are reduced, and areas of welding surfaces of all pads on a circuit board electrically connected to the male connector 100 are reduced, and/or areas of welding surfaces of all holder pins in a connector holder 200 are reduced, and areas of welding surfaces of all pads on a circuit board electrically connected to the connector holder 200 are reduced.

In Embodiment 4, for a structure of the male connector 100 and a structure of the connector holder 200, refer to Embodiment 1, Embodiment 2, and Embodiment 3. Details are not described in Embodiment 4.

In Embodiment 4, when the areas of the welding surfaces of all the male pins 102b in the male connector 100 are reduced, and the areas of the welding surfaces of all the pads on the circuit board electrically connected to the male connector 100 are reduced, in some examples, a value range of the area of the welding surface of the male pin 102b in the male connector 100 may be the same as the value range of the area of the welding surface of the first male pin 1042 in Embodiment 1. Refer to descriptions of the value range of the area of the welding surface of the first male pin 1042 in Embodiment 1. Details are not described herein again.

In some examples, a value range of a length of the welding surface of the male pin 102b along a width direction of the male connector 100 may be the same as the value range of the length of the welding surface of the first male pin 1042 along the width direction of the male connector 100 in Embodiment 1. Refer to descriptions of the value range of the length of the welding surface of the first male pin 1042 in Embodiment 1. Details are not described herein again.

In some examples, a value range of the width of the welding surface of the male pin 102b along a length direction of the male connector 100 may be the same as the value range of the width of the welding surface of the first male pin 1042 along the length direction of the male connector 100 in Embodiment 1. Refer to descriptions of the value range of the width of the welding surface of the first male pin 1042 in Embodiment 1. Details are not described herein again.

In some examples, value ranges of the areas of the welding surfaces of all the pads on the circuit board electrically connected to the male connector 100 may be the same as the value range of the area of the welding surface of the first male pad 3011 in Embodiment 1. Refer to descriptions of the value range of the area of the welding surface of the first male pad 3011 in Embodiment 1. Details are not described herein again.

In some examples, along a direction perpendicular to a first direction, a value range of lengths of the welding surfaces of all the pads on the circuit board electrically connected to the male connector 100 may be the same as the value range of the length of the welding surface of the first male pad 3011 along the direction perpendicular to the first direction in Embodiment 1. Refer to descriptions of the value range of the length of the welding surface of the first male pad 3011 in Embodiment 1. Details are not described herein again.

In some examples, along the first direction, a value range of widths of the welding surfaces of all the pads on the circuit board electrically connected to the male connector 100 may be the same as the value range of the width of the welding surface of the first male pad 3011 along the first direction in Embodiment 1. Refer to descriptions of the value range of the width of the welding surface of the first male pad 3011 in Embodiment 1. Details are not described herein again.

Because the areas of the welding surfaces of all the male pins 102b in the male connector 100 are reduced, and the areas of the welding surfaces of all the pads on the circuit board electrically connected to the male connector 100 are reduced, a parasitic capacitance between a reference ground layer of the circuit board and both the male pin 102b and the pad on the circuit board can be greatly reduced, thereby effectively increasing characteristic impedance of the male connector 100. In this way, a problem that the characteristic impedance of the male connector 100 does not match characteristic impedance of wiring on the circuit board can be obviously improved, reflection caused when a signal is transmitted between the male connector 100 and the circuit board is reduced, and SI is further improved.

In Embodiment 4, when the areas of the welding surfaces of all the holder pins in the connector holder 200 are reduced, and the areas of the welding surfaces of all the pads on the circuit board electrically connected to the connector holder 200 are reduced, in some examples, value ranges of the areas of the welding surfaces of all the holder pins in the connector holder 200 may be the same as the value range of the area of the welding surface of the first holder pin 2061 in Embodiment 2. Refer to descriptions of the value range of the area of the welding surface of the first holder pin 2061 in Embodiment 2. Details are not described herein again.

In some examples, a value range of lengths of the welding surfaces of all the holder pins in the connector holder 200 along a width direction of the connector holder 200 may be the same as the value range of the length of the welding surface of the first holder pin 2061 along the width direction of the connector holder 200 in Embodiment 2. Refer to descriptions of the value range of the length of the welding surface of the first holder pin 2061 in Embodiment 2. Details are not described herein again.

In some examples, a value range of widths of the welding surfaces of all the holder pins in the connector holder 200 along a length direction of the connector holder 200 may be the same as the value range of the width of the welding surface of the first holder pin 2061 along the length direction of the connector holder 200 in Embodiment 2. Refer to descriptions of the value range of the width of the welding surface of the first holder pin 2061 in Embodiment 2. Details are not described herein again.

In some examples, value ranges of the areas of the welding surfaces of all the pads on the circuit board electrically connected to the connector holder 200 may be the same as the value range of the area of the welding surface of the first holder pad 6011 in Embodiment 2. Refer to descriptions of the value range of the area of the welding surface of the first holder pad 6011 in Embodiment 2. Details are not described herein again.

In some examples, along a direction perpendicular to a first direction, value ranges of lengths of the welding surfaces of all the pads on the circuit board electrically connected to the connector holder 200 are the same as the value range of the length of the welding surface of the first holder pad 6011 along the direction perpendicular to the first direction in Embodiment 2. Refer to descriptions of the value range of the length of the welding surface of the first holder pad 6011 in Embodiment 2. Details are not described herein again.

In some examples, along the first direction, value ranges of widths of the welding surfaces of all the pads on the circuit board electrically connected to the connector holder 200 are the same as the value range of the width of the welding surface of the first holder pad 6011 along the first direction in Embodiment 2. Refer to descriptions of the value range of the width of the welding surface of the first holder pad 6011 in Embodiment 2. Details are not described herein again.

Because the areas of the welding surfaces of all the holder pins 206 in the connector holder 200 are reduced, the areas of the welding surfaces of all the pads on the circuit board electrically connected to the connector holder 200 are reduced, a parasitic capacitance between the reference ground layer of the circuit board and both the holder pins 206 and the pad on the circuit board can be greatly reduced, thereby effectively increasing characteristic impedance of the connector holder 200. In this way, a problem that the characteristic impedance of the connector holder 200 does not match the characteristic impedance of the wiring on the circuit board can be obviously reduced, reflection caused when a signal is transmitted between the connector holder 200 and the circuit board is reduced, and the SI is further improved.

Based on the foregoing descriptions, it should be noted that, when the areas of the welding surfaces of all the male pins 102b in the male connector 100 are reduced, the areas of the welding surfaces of all the pads on the circuit board electrically connected to the male connector 100 are reduced, or when the areas of the welding surfaces of all the holder pins in the connector holder 200 are reduced, and the areas of the welding surfaces of all the pads on the circuit board electrically connected to the connector holder 200 are reduced, when the areas of the welding surfaces of all the male pins 102b in the male connector 100 are reduced, and the areas of the welding surfaces of all the pads on the circuit board electrically connected to the male connector 100 are reduced, the connector holder 200 may be the connector holder 200 provided in Embodiment 1, or may be the connector holder 200 provided in Embodiment 2. When the areas of the welding surfaces of all the holder pins in the connector holder 200 are reduced, and the areas of the welding surfaces of all the pads on the circuit board electrically connected to the connector holder 200 are reduced, the male connector 100 may be the male connector 100 provided in Embodiment 1, or may be the male connector 100 provided in Embodiment 3.

**Claims**

1.  A connector body, comprising a first contact part and a second contact part, wherein the first contact part comprises a first contact terminal and a first pin electrically connected to the first contact terminal, and the second contact part comprises a second contact terminal and a second pin electrically connected to the second contact terminal, wherein the first contact terminal and the first pin electrically connected to the first contact terminal are integrally formed, the second contact terminal and the second pin electrically connected to the second contact terminal are integrally formed, and an area of a welding surface of the first pin is less than an area of a welding surface of the second pin.

2.  The connector body according to claim 1, wherein a value range of the area of the welding surface of the first pin is from 0.0016 mm$^2$ to 7.8804 mm$^2$, and a value range of the area of the welding surface of the second pin is from 0.004 mm$^2$ to 8 mm$^2$.

3.  The connector body according to claim 1 or 2, wherein a difference between the area of the welding surface of the second pin and the area of the welding surface of the first pin ranges from 0.024 mm$^2$ to 7.9984 mm$^2$.

4.  The connector body according to claim 1, wherein the first contact part and the second contact part are arranged along a length direction of the connector body; and
    along a width direction of the connector body, a length of the welding surface of the first pin is less than a length of the welding surface of the second pin.

5.  The connector body according to claim 4, wherein along the width direction of the connector body, a value range of the length of the welding surface of the first pin is from 0.02 mm to 3.98 mm, and a value range of the length of the welding surface of the second pin is from 0.04 mm to 4 mm.

6.  The connector body according to claim 4 or 5, wherein along the width direction of the connector body, a difference between the length of the welding surface of the second pin and the length of the welding surface of the first pin ranges from 0.02 mm to 3.98 mm.

7.  The connector body according to claim 1, wherein the first pin is a high-speed signal pin, and the second pin is a non-high-speed signal pin.

8.  The connector body according to claim 7, wherein the non-high-speed signal pin is a low-speed signal pin, a power pin, or a ground pin.

9.  The connector body according to claim 1, wherein the first contact part and the second contact part are arranged along a length direction of the connector body; and

an area of a section that is of the first contact terminal and that is along a width direction of the connector body is less than an area of a section that is of the second contact terminal and that is along the width direction of the connector body.

10. A connector, comprising a male connector and a connector holder, wherein the male connector is connected to the connector holder through buckling; and

the male connector is the connector body according to any one of claims 1 to 9; and/or the connector holder is the connector body according to any one of claims 1 to 9.

11. The connector according to claim 10, wherein the male connector comprises a first contact part and a second contact part, and the connector holder comprises a first contact part and a second contact part, wherein

a first contact terminal in the first contact part of the male connector is connected to a first contact terminal in the first contact part of the connector holder through buckling, and a second contact terminal in the second contact part of the male connector is connected to a second contact terminal in the second contact part of the connector holder through buckling.

12. The connector according to claim 11, wherein the first contact terminal of the male connector is connected to the first contact terminal of the connector holder through buckling by using one contact point, and the second contact terminal of the male connector is connected to the second contact terminal of the connector holder through buckling by using a plurality of contact points.

13. The connector according to claim 12, wherein the male connector further comprises an auxiliary contact terminal, and a material of the auxiliary contact terminal is a non-conductive material; and

the first contact terminal of the male connector is further connected to the first contact terminal of the connector holder through buckling by using the auxiliary contact terminal.

14. The connector according to claim 13, wherein the connector is a board to board BTB connector, a type-C connector, a low voltage differential signaling LVDS connector, an M.2 connector, or a WTB connector.

15. A circuit board, comprising a signal terminal layer and a reference ground layer that are disposed in a stacked manner, wherein the reference ground layer covers the signal terminal layer, and the signal terminal layer comprises a first pad and a second pad, wherein

an area of a welding surface of the first pad is less than an area of a welding surface of the second pad.

16. The circuit board according to claim 15, wherein a value range of the area of the welding surface of the first pad is from $0.0055 \ mm^2$ to $23.8004 \ mm^2$, and a value range of the area of the welding surface of the second pad is from $0.0091 \ mm^2$ to $24 \ mm^2$.

17. The circuit board according to claim 15 or 16, wherein a difference between the area of the welding surface of the second pad and the area of the welding surface of the first pad ranges from $0.0036 \ mm^2$ to $23.9945 \ mm^2$.

18. The circuit board according to claim 15, wherein the first pad and the second pad are arranged along a first direction; and

along a direction perpendicular to the first direction, a length of the welding surface of the first pad is less than a length of the welding surface of the second pad.

19. The circuit board according to claim 18, wherein along the direction perpendicular to the first direction, a value range of the length of the welding surface of the first pad is from 0.05 mm to 5.98 mm, and a range of the length of the welding surface of the second pad is from 0.07 mm to 6 mm.

20. The circuit board according to claim 18 or 19, wherein along the direction perpendicular to the first direction, a difference between the length of the welding surface of the second pad and the length of the welding surface of the first pad ranges from 0.02 mm to 5.95 mm.

21. The circuit board according to claim 15, wherein the circuit board is a printed circuit board or a flexible circuit board.

22. An electronic device, comprising a circuit board and a connector body mounted on the circuit board, wherein

the connector body is the connector body according to any one of claims 1 to 9, and the circuit board is the circuit board according to any one of claims 15 to 21; and

a welding surface of a first pin of the connector body is welded on a welding surface of a first pad of the circuit board, and a welding surface of a second pin of the connector body is welded on a welding surface of a second pad of the circuit board.

23. The electronic device according to claim 22, wherein the connector body is a male connector or a connector holder.

24. An electronic system, comprising the connector according to any one of claims 10 to 14, a first electronic component, and a second electronic component, wherein a male connector is electrically connected to the first electronic component, and a connector holder is electrically connected to the second electronic component;

the male connector comprises a first pin and a second pin, an area of a welding surface of the first pin is less than an area of a welding surface of the second pin, the first electronic component is the circuit board according to any one of claims 15 to 21, the first pin of the male connector is electrically connected to a first pad of the first electronic component, and the second pin of the male connector is electrically connected to a second pad of the first electronic component; and/or

the connector holder comprises a first pin and a second pin, an area of a welding surface of the first pin is less than an area of a welding surface of the second pin, the second electronic component is the circuit board according to any one of claims 15 to 21, the first pin of the connector holder is electrically connected to a first pad of the second electronic component, and the second pin of the connector holder is electrically connected to a second pad of the second electronic component.

25. The electronic system according to claim 24, wherein the electronic system is a first electronic device, and the connector, the first electronic component, and the second electronic component are disposed in the first electronic device.

26. The electronic system according to claim 24, wherein the electronic system comprises a first electronic device and a second electronic device; and

the male connector and the first electronic component are disposed in the first electronic device, and the connector holder and the second electronic component are disposed in the second electronic device.

FIG. 1

FIG. 2

FIG. 3

FIG. 4

100

1042        1052

FIG. 5

100

101

104
1041
1042
1051
105
1052
102
104
105
104

FIG. 6

104 (105)

1041 (1051)

1042 (1052)

FIG. 7a

104

1041

1042

FIG. 7b

300 (600)

301 (601)

302 (602)

3012 (6012)

3011 (6011)

303 (603)

FIG. 8

FIG. 9a

FIG. 9b

FIG. 10

200

202(206)

FIG. 11

200  203

204

201

202

FIG. 12

202 (207/208)

206 (2061/2062)

205 (2051/2052)

FIG. 13

400    401    402

4011

403

FIG. 14

FIG. 15a

EP 4 297 192 A1

FIG. 15b

FIG. 16

FIG. 17

500    501

502

5011

5011a

5021

503

FIG. 18

200

30

Z
Y
X

FIG. 19

200

FIG. 20

2061    2062

206

200

203

204

201

207 (202) { 2051 (205)
              2061 (206)

2062 (206)

2052 (205)

208 (202)

FIG. 21

## INTERNATIONAL SEARCH REPORT

International application No.

**PCT/CN2022/083211**

| A. | CLASSIFICATION OF SUBJECT MATTER |
|---|---|

H01R 12/70(2011.01)i; H01R 13/6473(2011.01)i

According to International Patent Classification (IPC) or to both national classification and IPC

| B. | FIELDS SEARCHED |
|---|---|

Minimum documentation searched (classification system followed by classification symbols)

H01R

Documentation searched other than minimum documentation to the extent that such documents are included in the fields searched

Electronic data base consulted during the international search (name of data base and, where practicable, search terms used)

CNTXT; ENTXT; ENTXTC; DWPI; CNKI: 端子, 接触件, 引脚, 焊脚, 焊接, 面积, 长度; terminal, contact, pin, fillet, weld, solder, area, length

| C. | DOCUMENTS CONSIDERED TO BE RELEVANT | |
|---|---|---|

| Category* | Citation of document, with indication, where appropriate, of the relevant passages | Relevant to claim No. |
|---|---|---|
| PX | CN 215497153 U (HUAWEI TECHNOLOGIES CO., LTD.) 11 January 2022 (2022-01-11)<br>claims 1-26 | 1-26 |
| X | CN 210779073 U (HUAWEI TECHNOLOGIES CO., LTD.) 16 June 2020 (2020-06-16)<br>description, paragraphs 61-113, and figures 1-6 | 1-14 |
| Y | CN 210779073 U (HUAWEI TECHNOLOGIES CO., LTD.) 16 June 2020 (2020-06-16)<br>description, paragraphs 61-113, and figures 1-6 | 22-26 |
| X | CN 110213880 A (INNOLIGHT TECHNOLOGY CORPORATION) 06 September 2019<br>(2019-09-06)<br>description, paragraphs 40-59, and figures 6-10 | 15-21 |
| Y | CN 110213880 A (INNOLIGHT TECHNOLOGY CORPORATION) 06 September 2019<br>(2019-09-06)<br>description, paragraphs 40-59, and figures 6-10 | 22-26 |
| A | CN 208256950 U (SHENZHEN KRCONN TECHNOLOGY CO., LTD.) 18 December 2018<br>(2018-12-18)<br>entire document | 1-26 |
| A | US 2015313005 A1 (TAKABATAKE, M. et al.) 29 October 2015 (2015-10-29)<br>entire document | 1-26 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **02 June 2022** | **10 June 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2022/083211**

| Patent document cited in search report | | | Publication date (day/month/year) | Patent family member(s) | | | Publication date (day/month/year) |
|---|---|---|---|---|---|---|---|
| CN | 215497153 | U | 11 January 2022 | None | | | |
| CN | 210779073 | U | 16 June 2020 | None | | | |
| CN | 110213880 | A | 06 September 2019 | CN | 110213880 | B | 25 August 2020 |
| CN | 208256950 | U | 18 December 2018 | None | | | |
| US | 2015313005 | A1 | 29 October 2015 | JP | 5770936 | B2 | 26 August 2015 |
| | | | | WO | 2013186927 | A1 | 19 December 2013 |
| | | | | JPWO2013186927 | | S | 01 February 2016 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202120653373